# EUROPÄISCHE PATENTSCHRIFT

(11) **EP 4 260 419 B1**
(45) Veröffentlichungstag und Bekanntmachung des Hinweises auf die Patenterteilung: **05.02.2025**
(21) Anmeldenummer: 21835681.4
(22) Anmeldetag: 09.12.2021
(51) Int. Cl.: H01S 5/40

(54) **LICHT EMITTIERENDER HALBLEITERCHIP UND VERFAHREN ZUR HERSTELLUNG EINES LICHT EMITTIERENDEN HALBLEITERCHIPS**
LIGHT-EMITTING SEMICONDUCTOR CHIP AND METHOD FOR PRODUCING A LIGHT-EMITTING SEMICONDUCTOR CHIP
PUCE À SEMI-CONDUCTEUR ÉLECTROLUMINESCENTE ET PROCÉDÉ DE FABRICATION D'UNE PUCE À SEMI-CONDUCTEUR ÉLECTROLUMINESCENTE

(30) Priorität: 11.12.2020 DE 102020133177
(43) Veröffentlichungstag der Anmeldung: 18.10.2023
(73) Patentinhaber: ams-OSRAM International GmbH, 93055 Regensberg (DE)
(72) Erfinder: NÄHLE, Lars, 93077 Bad Abbach (DE); EICHLER, Christoph, 93093 Donaustauf (DE)
(74) Vertreter: Epping - Hermann - Fischer
(86) Internationale Anmeldenummer: PCT/EP2021/084996
(87) Internationale Veröffentlichungsnummer: WO 2022/122920

(56) Entgegenhaltungen:
- WO-A1-01/22543
- WO-A2-02/31863
- JP-A- 2009 152 277
- US-A- 4 831 629
- US-A1- 2004 113 164
- US-A1- 2019 348 568
- VOEGELI O ET AL: "FULL-WAFER TECHNOLOGY FOR LARGE-SCALE LASER PROCESSING AND TESTING", JOURNAL OF VACUUM SCIENCE AND TECHNOLOGY: PART B, AVS / AIP, MELVILLE, NEW YORK, NY, US, vol. 9, no. 6, 1 November 1991 (1991-11-01), pages 2886 - 2892, XP000268495, ISSN: 1071-1023, DOI: 10.1116/1.585619

## Beschreibung

Es werden ein Licht emittierender Halbleiterchip und ein Verfahren zur Herstellung eines Licht emittierenden Halbleiterchips angegeben.

Diese Patentanmeldung beansprucht die Priorität der deutschen Patentanmeldung 102020133177. 0.

In optischen Geräten wie beispielsweise Projektoren, sogenannten VR- und/oder AR-Brillen (VR: "virtual reality", virtuelle Realität; AR: "augmented reality", erweiterte Realität) etc. werden oft Laserlichtquellen verwendet. Durch die physikalische Natur von kohärenter Laserstrahlung kann es jedoch zu bestimmten Bildartefakten wie beispielsweise Interferenzen und/oder einer als Speckles (Flecken) bezeichnete Lichtgranulation oder ähnlichem kommen, die in vielen Anwendungen unerwünscht sind. Um diesbezüglich die Bildqualität zu verbessern, kann es hilfreich sein, mit Mehrfach-Emitter-Bauteilen zu arbeiten, die im Optimalfall zueinander verschobene Emissionswellenlängen aufweisen. Besonders vorteilhaft können hierbei Bauteile mit 2, 3, 4 oder mehr Emittern sein, deren Emissionswellenlängen definiert gegeneinander verschoben sind.

Durch Variation der Lasergeometrie wie beispielsweise Ridgebreite, Resonatorlänge und/oder Verspiegelung können zwar Veränderungen der Wellenlänge erreicht werden. Allerdings gehen diese Wellenlängenänderungen üblicherweise auch mit einer Änderung von Laserparametern wie Schwelle, Steilheit und Operationsstrom einher, was unerwünscht ist, da alle Emitter auf einem Chip vergleichbare Laserparameter aufweisen sollten. Durch Mehrfach-Epitaxie können ebenfalls Emitter mit unterschiedlicher Wellenlänge hergestellt werden. Dies erfordert jedoch einen hohen technischen Aufwand und ist teuer. Auch durch verspannungsändernde Strukturen auf dem Wafer kann die Epitaxie in einer Weise beeinflusst werden, dass sich lokal unterschiedliche Wellenlängen ausbilden. Diese Strukturen benötigen jedoch zusätzlich Platz auf dem Chip, was teuer ist, und können unerwünschte Nebenwirkungen auf Laserparameter wie beispielsweise die Fernfeldbreite haben.

Die bisher gewählten Ansätze, beispielsweise eine Variation der Lichtwellenleiter-Geometrie-Parameter und/oder der Verspiegelung, sind somit technisch teilweise sehr schwer umzusetzen und führen unweigerlich zur Variation der Betriebsparameter mit der Emissionswellenlänge, wohingegen eine Beibehaltung vergleichbarer Betriebsparameter wünschenswert wäre.

Halbleiterlaser sind beispielsweise aus den Druckschriften O. Voegeli et al., "Full-wafer technology for large-scale laser processing and testing", J. Vac. Sci. Technol. B 9(6), Nov/Dec 1991, S. 2886-2892, US 2019/348568 A1, US 2004/0113164 A1 und WO 01/22543 A1 bekannt.

Zumindest eine Aufgabe von bestimmten Ausführungsformen ist es, einen Licht emittierenden Halbleiterchip anzugeben.

Zumindest eine weitere Aufgabe von bestimmten Ausführungsformen ist es, ein Verfahren zur Herstellung eines Licht emittierenden Halbleiterchips anzugeben.

Diese Aufgaben werden durch einen Gegenstand und ein Verfahren gemäß den unabhängigen Patentansprüchen gelöst. Vorteilhafte Ausführungsformen und Weiterbildungen des Gegenstands und des Verfahrens sind in den abhängigen Ansprüchen gekennzeichnet und gehen weiterhin aus der nachfolgenden Beschreibung und den Zeichnungen hervor.

Gemäß zumindest einer Ausführungsform umfasst ein Licht emittierender Halbleiterchip einen Halbleiterkörper mit zumindest einer Emittereinheit. Bevorzugt weist der Licht emittierende Halbleiterchip eine Mehrzahl von Emittereinheiten, also beispielsweise größer oder gleich 2 oder größer oder gleich 3 oder größer oder gleich 4 Emittereinheiten auf. Besonders bevorzugt können die Emittereinheiten, sofern nicht anders beschrieben, gleich oder zumindest ähnlich ausgebildet sein. Besonders bevorzugt ist die Mehrzahl der Emittereinheiten monolithisch im Halbleiterkörper ausgebildet. Bei einem Verfahren zur Herstellung des Licht emittierenden Halbleiterchips wird der Halbleiterkörper aufgewachsen, beispielsweise auf einem Substrat, wobei der Halbleiterkörper die eine oder die Mehrzahl der Emittereinheiten aufweist. Die im Folgenden beschriebenen Merkmale gelten, sofern nicht anders angegeben, gleichermaßen für einen Licht emittierenden Halbleiterchip mit einer Emittereinheit sowie auch für einen Licht emittierenden Halbleiterchip mit einer Mehrzahl von Emittereinheiten. Die nachfolgende Beschreibung gilt weiterhin gleichermaßen für den Licht emittierenden Halbleiterchip als auch für das Verfahren zur Herstellung des Licht emittierenden Halbleiterchips.

Jede der zumindest einen Emittereinheit weist einen aktiven Bereich auf, der dazu eingerichtet und vorgesehen ist, im Betrieb Licht zu erzeugen. Mit Licht kann hier und im Folgenden insbesondere elektromagnetische Strahlung mit einer oder mehreren spektralen Komponenten in einem infraroten bis ultravioletten Wellenlängenbereich bezeichnet werden. Entsprechend können die Begriffe Licht, Strahlung und elektromagnetische Strahlung synonym verwendet sein. Das im aktiven Bereich erzeugte Licht kann durch eine charakteristische Wellenlänge spezifiziert sein. Die charakteristische Wellenlänge kann dabei die intensitätsstärkste Wellenlänge des Spektrums des erzeugten Lichts bezeichnen. Alternativ kann die charakteristische Wellenlänge auch die mittlere Wellenlänge des Spektralbereichs, in dem das erzeugte Licht liegt, bezeichnen. Weiterhin kann die charakteristische Wellenlänge auch die über die einzelnen spektralen Intensitäten gewichtete mittlere Wellenlänge des Spektrums des erzeugten Lichts bezeichnen.

Weiterhin ist der aktive Bereich jeder der zumindest einen Emittereinheit in einem Resonator angeordnet. Der Resonator ist insbesondere dazu ausgebildet, das Licht, das im aktiven Bereich erzeugt wird, zu verstärken. Beispielsweise durch den Resonator kann eine Abstrahlrichtung definiert sein, entlang derer von einer Emittereinheit im Betrieb Licht emittiert wird.

Der Halbleiterkörper kann je nach Wellenlänge als Halbleiterschichtenfolge auf der Basis von verschiedenen Halbleitermaterialsystemen hergestellt werden. Für eine langwellige, infrarote bis rote Strahlung ist beispielsweise eine Halbleiterschichtenfolge auf Basis von InₓGa_{y}Al_{1-x-y}As, für rote bis gelbe Strahlung beispielsweise eine Halbleiterschichtenfolge auf Basis von InₓGa_{y}Al_{1-x-y}P und für kurzwellige sichtbare, also insbesondere im Bereich von grünem bis blauem Licht, und/oder für UV-Strahlung beispielsweise eine Halbleiterschichtenfolge auf Basis von InₓGa_{y}Al_{1-x-y}N geeignet, wobei jeweils 0 ≤ x ≤ 1 und 0 ≤ y ≤ 1 gilt.

Insbesondere kann der Halbleiterkörper eine Halbleiterschichtenfolge, besonders bevorzugt eine epitaktisch gewachsene Halbleiterschichtenfolge, aufweisen oder daraus sein. Der Halbleiterkörper kann insbesondere auf einem Substrat aufgebracht sein. Dazu kann die Halbleiterschichtenfolge mittels eines Epitaxieverfahrens, beispielsweise metallorgansicher Gasphasenepitaxie (MOVPE) oder Molekularstrahlepitaxie (MBE), auf einem Aufwachssubstrat aufgewachsen und mit elektrischen Kontakten versehen werden. Durch Vereinzelung des Aufwachssubstrats mit der aufgewachsenen Halbleiterschichtenfolge kann eine Mehrzahl von Licht emittierenden Halbleiterchips hergestellt werden. Weiterhin kann der Halbleiterkörper vor dem Vereinzeln auf ein Trägersubstrat übertragen werden und das Aufwachssubstrat kann gedünnt oder ganz entfernt werden. Das Substrat kann ein Halbleitermaterial, beispielsweise ein oben genanntes Verbindungshalbleitermaterialsystem umfassen. Insbesondere kann das Substrat Saphir, GaAs, GaP, GaN, InP, SiC, Si und/oder Ge aufweisen oder aus einem solchen Material sein.

Der Halbleiterkörper und insbesondere die zumindest eine Emittereinheit kann als aktiven Bereich beispielsweise einen herkömmlichen pn-Übergang, eine Doppelheterostruktur, eine Einfach-Quantentopfstruktur (SQW-Struktur) oder eine Mehrfach-Quantentopfstruktur (MQW-Struktur) aufweisen. Weiterhin sind beispielsweise auch Kaskaden von Typ-II-Übergängen (ICL: "interband cascade laser", Zwischenbandkaskadenlaser) oder auch Übergänge nur im Leitungsband (QCL: "quantum cascade laser", Quantenkaskadenlaser) möglich. Der Halbleiterkörper kann neben dem aktiven Bereich weitere funktionale Schichten und funktionelle Bereiche umfassen, etwa p- oder n-dotierte Ladungsträgertransportschichten, also Elektronen- oder Löchertransportschichten, undotierte oder p- oder n-dotierte Confinement-, Cladding- oder Wellenleiterschichten, Barriereschichten, Planarisierungsschichten, Pufferschichten, Schutzschichten und/oder elektrische Kontaktstellen wie Elektrodenschichten sowie Kombinationen daraus. Darüber hinaus können zusätzliche Schichten, etwa Pufferschichten, Barriereschichten und/oder Schutzschichten auch senkrecht zur Aufwachsrichtung des Halbleiterkörpers beispielsweise um den Halbleiterkörper herum angeordnet sein, also etwa auf den Seitenflächen des Halbleiterkörpers.

Beispielsweise kann der aktive Bereich jeder der Emittereinheiten als ein Lasermedium ausgebildet sein, in dem im Betrieb in Verbindung mit einem geeigneten Resonator eine Besetzungsinversion erzeugt wird. Aufgrund der Besetzungsinversion wird das Licht im aktiven Bereich durch stimulierte Emission erzeugt, die zur Ausbildung von Laserlicht führt. Aufgrund der Erzeugung des Lichts durch stimulierte Emission weist das Laserlicht im Unterschied zu Licht, das durch spontane Emission erzeugt wird, in der Regel eine sehr hohe Kohärenzlänge, ein sehr schmales Emissionsspektrum und/oder einen hohen Polarisationsgrad auf. Das im aktiven Bereich erzeugte Laserlicht bildet eine oder mehrere stehende Wellen innerhalb des jeweiligen Resonators entsprechend einer jeweiligen Länge des Resonators aus. Hierzu kann die Länge des jeweiligen Resonators in der Regel ein ganzzahliges Vielfaches der halben Wellenlänge des im aktiven Bereich im Betrieb erzeugten Lichts aufweisen.

Gemäß einer weiteren Ausführungsform weist der Resonator jeder der Emittereinheiten eine Auskoppelseite und eine Rückseite auf. Insbesondere können die Auskoppelseite und die Rückseite durch sich gegenüber liegende Seitenflächen des Halbleiterkörpers gebildet werden. Über die Auskoppelseite kann eine Emittereinheit im Betrieb Licht abstrahlen. Hierzu kann die Auskoppelseite entspiegelt oder bevorzugt teilverspiegelt sein. Die Rückseite kann so ausgebildet sein, dass kein Licht oder zumindest weniger Licht als über die Auskoppelseite abgestrahlt wird. Die Rückseite kann somit beispielsweise vollverspiegelt oder auch teilverspiegelt sein. Weiterhin kann es auch möglich sein, dass die Rückseite entspiegelt ist.

"Entspiegelt" kann hier und im Folgenden bedeuten, dass möglichst keine Reflexion stattfindet, was einem Reflexionskoeffizienten von kleiner oder gleich 5% oder kleiner oder gleich 2% oder bevorzugt von kleiner oder gleich 1% entsprechen kann. 'Vollverspiegelt" kann hier und im Folgenden bedeuten, dass möglichst keine Transmission stattfindet, was einem Reflexionskoeffizienten von größer oder gleich 95% oder von größer oder gleich 98% oder bevorzugt von größer oder gleich 99% entsprechen kann. "Teilverspiegelt" kann hier und im Folgenden bedeuten, dass ein Reflexionskoeffizient vorliegt, der zwischen den vorgenannten Werten für entspiegelt und vollverspiegelt liegt. Begriffe wie "entspiegelt", "teilverspiegelt", "vollverspiegelt", "reflektierend" etc. beziehen sich vorab und im Folgenden, soweit nicht anders angegeben, auf das im aktiven Bereich der Emittereinheiten erzeugte Licht.

Gemäß einer weiteren Ausführungsform weisen die Abstrahlrichtungen der Emittereinheiten in eine gleiche Richtung. Die Emittereinheiten des Licht emittierenden Halbleiterchips emittieren somit im Betrieb Licht in eine gleiche Richtung. Weiterhin können die Emittereinheiten besonders bevorzugt senkrecht zur Abstrahlrichtung nebeneinander im Halbleiterkörper ausgebildet sein, so dass die Auskoppelseite und die Rückseite der Emittereinheiten bevorzugt durch jeweils gleiche Seitenflächen des Halbleiterkörpers gebildet werden können.

Gemäß einer weiteren Ausführungsform ist bei jeder Emittereinheit der aktive Bereich durch zumindest eine Ausnehmung im Halbleiterkörper vollständig durchdrungen. Das kann bedeuten, dass jede Emittereinheit zumindest eine Ausnehmung aufweist, die den aktiven Bereich vollständig durchdringt. Mit anderen Worten ist der aktive Bereich einer jeden Emittereinheit durch eine Ausnehmung unterbrochen. Die zumindest eine Ausnehmung ist beispielsweise als Spalt oder Schlitz ausgebildet und weist besonders bevorzugt eine Haupterstreckungsrichtung auf, die nicht-parallel und bevorzugt senkrecht zur Abstrahlrichtung ist.

Gemäß einer weiteren Ausführungsform weist jede der Emittereinheiten eine Ausnehmung auf, die von den Ausnehmungen der anderen Emittereinheiten getrennt ist. Mit anderen Worten weist der Halbleiterkörper separate Ausnehmungen auf, wobei der aktive Bereich jeder Emittereinheit durch eine eigens zugeordnete Ausnehmung durchdrungen ist. Alternativ hierzu kann im Halbleiterkörper auch eine Ausnehmung vorhanden sein, die sich durch die aktiven Bereiche von zwei oder mehreren und bevorzugt allen Emittereinheiten erstreckt. Im letzteren Fall können somit alle aktiven Bereiche des Licht emittierenden Halbleiterchips durch eine einzige Ausnehmung durchdrungen sein.

Die nachfolgend beschriebenen Ausführungsformen und Merkmale für die zumindest eine Ausnehmung beziehen sich sowohl auf den Fall, dass jede der Emittereinheiten eine eigens zugeordnete Ausnehmung aufweist, als auch auf den Fall, dass sich eine gemeinsame Ausnehmung durch die aktiven Bereiche von mehr als einer Emittereinheit erstreckt. Somit kann die im Folgenden genannte zumindest eine Ausnehmung eine jeder Emittereinheit eigens zugeordnete Ausnehmung oder auch eine gemeinsame Ausnehmung bezeichnen.

Gemäß einer weiteren Ausführungsform weist für jede Emittereinheit die zumindest eine Ausnehmung eine erste Seitenfläche und eine zweite, der ersten Seitenfläche gegenüberliegende Seitenfläche auf. Die erste und zweite Seitenfläche sind insbesondere in Abstrahlrichtung hintereinander angeordnet und sind somit diejenigen Seitenflächen der zumindest einen Ausnehmung, durch die die zumindest eine Ausnehmung entlang der Abstrahlrichtung begrenzt ist. Beispielsweise weist die Ausnehmung eine rechteckige Grundfläche auf. Beispielsweise verlaufen die erste Seitenfläche und die zweite Seitenfläche parallel zur Haupterstreckungsrichtung. Weiterhin kann die Ausnehmung beispielsweise eine keilförmige und/oder eine zumindest teilweise abgerundete Grundfläche aufweisen. Hierzu kann zumindest eine Seitenfläche zumindest teilweise schräg zur Haupterstreckungsrichtung und/oder zumindest teilweise gebogen verlaufen.

Für jede Emittereinheit weist die zumindest eine Ausnehmung im Bereich des aktiven Bereichs eine Ausnehmungsbreite auf, die entlang der Abstrahlrichtung gemessen wird. Insbesondere kann die Ausnehmungsbreite somit in einer Richtung gemessen werden, die senkrecht oder im Wesentlichen senkrecht zur Haupterstreckungsrichtung der Ausnehmung ist. Im Fall einer Ausnehmung mit einer nicht-rechteckigen Grundfläche kann die Ausnehmungsbreite bevorzugt eine mittlere Breite sein, die über den Bereich gemittelt ist, in dem im Betrieb in der jeweiligen Emittereinheit Licht erzeugt wird. Bevorzugt beträgt für jede Emittereinheit die Ausnehmungsbreite größer oder gleich 100 nm oder größer oder gleich 300 nm oder größer oder gleich 500 nm und kleiner oder gleich 20 µm oder kleiner oder gleich 10 µm oder kleiner oder gleich 5 µm.

Gemäß einer weiteren Ausführungsform sind die Ausnehmungsbreiten der Emittereinheiten zumindest teilweise unterschiedlich. Mit anderen Worten weisen zumindest eine erste Emittereinheit eine erste Ausnehmungsbreite und zumindest eine zweite Emittereinheit eine zweite Ausnehmungsbreite auf, wobei die erste und zweite Ausnehmungsbreite verschieden sind. Im Fall von mehr als zwei Emittereinheiten sind die jeweiligen Ausnehmungsbreiten bevorzugt jeweils paarweise und somit alle verschieden. Weiterhin ist es auch möglich, dass beispielsweise Gruppen von zwei, drei oder mehr Emittereinheiten, also beispielsweise Paare oder Tripel von Emittereinheiten, eine gleiche Ausnehmungsbreite aufweisen, sich jedoch die Ausnehmungsbreiten von Gruppe zu Gruppe unterscheiden. Die Gruppen können gleiche oder unterschiedliche Anzahlen von Emittereinheiten aufweisen. Somit kann es beispielsweise auch möglich sein, dass die Mehrzahl der Emittereinheiten eine Gruppe von mehreren Emittereinheiten mit einer jeweils gleichen Ausnehmungsbreite aufweist, während die restlichen Emittereinheiten der Mehrzahl der Emittereinheiten voneinander unterschiedliche Ausnehmungsbreiten aufweisen. Durch mehrere Emittereinheiten einer Gruppe kann das jeweilige Emissionsspektrum beispielsweise im Gesamtspektrum verstärkt werden, wodurch die Farbwiedergabe verbessert werden kann. Im Fall von getrennt ausgebildeten Ausnehmungen für die Emittereinheiten kann jede der Ausnehmungen besonders bevorzugt mit einer Ausnehmungsbreite ausgebildet sein, die sich von den Ausnehmungsbreiten der anderen Emittereinheiten unterscheidet. Im Fall einer Ausnehmung, die sich durch die aktiven Bereiche von mehreren oder bevorzugt allen Emittereinheiten erstreckt, kann die Ausnehmungsbreite der zumindest einen Ausnehmung von Emittereinheit zu Emittereinheit kontinuierlich oder stufenförmig zunehmen.

Die Ausnehmungsbreiten der Emittereinheiten können sich um einen Betrag unterscheiden, der größer oder gleich 1 nm oder größer oder gleich 2 nm oder größer oder gleich 5 nm oder größer oder gleich 10 nm ist. Weiterhin können sich die Ausnehmungsbreiten der Emittereinheiten einen Betrag unterscheiden, der kleiner oder gleich 2 µm oder kleiner oder gleich 1 µm oder kleiner oder gleich 500 nm oder kleiner oder gleich 200 nm oder kleiner oder gleich 100 nm oder kleiner oder gleich 90 nm oder kleiner oder gleich 75 nm oder kleiner oder gleich 60 nm oder kleiner oder gleich 50 nm sind. Weiterhin können sich die Ausnehmungsbreiten der Emittereinheiten um einen Betrag unterscheiden, der größer oder gleich 1% oder größer oder gleich 2% oder größer oder gleich 5% oder größer oder gleich 10% und kleiner oder gleich 25% oder kleiner oder gleich 20% oder größer oder gleich 15% oder kleiner oder gleich 10% der charakteristischen Wellenlänge des in den Emittereinheiten im Betrieb erzeugten Lichts ist.

Gemäß einer weiteren Ausführungsform weist der Licht emittierende Halbleiterchip zumindest drei Emittereinheiten auf, wobei sich die Ausnehmungsbreiten der Emittereinheiten äquidistant voneinander unterscheiden. Mit anderen Worten kann der Licht emittierende Halbleiterchip eine erste Emittereinheit mit einer ersten Ausnehmungsbreite, eine zweite Emittereinheit mit einer zweiten Ausnehmungsbreite und eine dritte Emittereinheit mit einer dritten Ausnehmungsbreite aufweisen. Die Differenz zwischen der ersten und zweiten Ausnehmungsbreite ist bei einem äquidistanten Unterschied gleich der Differenz zwischen der zweiten Ausnehmungsbreite und der dritten Ausnehmungsbreite. Im Fall einer vierten Emittereinheit mit einer vierten Ausnehmungsbreite ist die Differenz zwischen der dritten und vierten Ausnehmungsbreite gleich den beiden vorgenannten Differenzen. Sind mehr als vier Emittereinheiten vorhanden, gilt bevorzugt das Vorgenannte analog.

Beim hier beschriebenen Licht emittierenden Halbleiterchip wird für jede Emittereinheit zumindest eine Ausnehmung, beispielsweise in Form eines Schlitzes, eingebracht. Die zumindest eine Ausnehmung kann beispielsweise durch eine Fototechnik definiert und durch Plasmaätzen und/oder nasschemisches Ätzen hergestellt werden. Insbesondere können alle Ausnehmungen des Halbleiterkörpers gemeinsam in denselben Verfahrensschritten hergestellt werden. Durch die zumindest eine Ausnehmung im aktiven Bereich jeder Emittereinheit kann eine wellenlängenabhängige Reflektivität erzielt werden, wobei das Reflexionsspektrum von der Ausnehmungsbreite, also der Schlitzbreite, beeinflusst wird.

Bei einem Licht emittierenden Halbleiterchip mit mehreren Emittereinheiten hätten typischerweise alle Emittereinheiten in Bezug auf das jeweils erzeugte Licht die gleiche Wellenlänge bei gleichen Betriebsparametern. Sollen diese jedoch Emissionswellenlängen aufweisen, die sich voneinander um einen bestimmten Betrag unterscheiden, kann dies dadurch erreicht werden, dass die Ausnehmungsbreite wie vorab beschrieben von Emittereinheit zu Emittereinheit variiert wird. Beispielsweise kann die Ausnehmungsbreite von einer ersten Emittereinheit zu einer letzten Emittereinheit hin immer größer werden. Dadurch verschiebt sich das Reflexionsmaximum, sodass die verschiedenen Emittereinheiten auf unterschiedliche Wellenlängen gezwungen werden. Die Betriebsparameter, also im Fall einer Laserlichtquelle die Laserparameter wie Schwelle, Steilheit und Spannung ändern sich dadurch im Wesentlichen nicht. Für alle folgenden Ausführungsformen gilt, dass die spektrale Anpassung der Emittereinheiten durch die Änderung der Ausnehmungsbreite technisch einfach zu realisieren ist, die Betriebsparameter aber zumindest im Wesentlichen nicht beeinflusst werden.

Für jede Emittereinheit kann die zumindest eine Ausnehmung bevorzugt dazu vorgesehen und eingerichtet sein, verschiedene Segmente der Emittereinheiten des Halbleiterkörpers elektrisch und/oder optisch voneinander zu isolieren. Die Segmente der Emittereinheiten können gleiche oder verschiedene Funktionalitäten aufweisen.

Gemäß einer weiteren Ausführungsform weist für jede Emittereinheit die zumindest eine Ausnehmung zumindest eine Beschichtung auf, die eine Reflektivität der Ausnehmung für das im aktiven Bereich erzeugte Licht vorgibt. Mit anderen Worten kann mittels der Beschichtung, die beispielsweise in Form von einer oder mehreren Schichten auf zumindest einer oder mehreren Seitenflächen der zumindest einen Ausnehmung und/oder als Füllung ausgebildet sein kann, eine gewünschte Reflektivität der zumindest einen Ausnehmung für das im aktiven Bereich erzeugte Licht der jeweiligen Emittereinheit eingestellt werden. Alternativ dazu kann die zumindest eine Ausnehmung für eine oder mehrere oder alle Emittereinheiten auch frei von einer Beschichtung sein. Die Reflektivität der Ausnehmung kann für jede Emittereinheit insbesondere so eingestellt werden, dass die zumindest eine Ausnehmung entspiegelt, teilverspiegelt oder vollverspiegelt gemäß der Beschreibung weiter oben ist. Besonders bevorzugt weisen die Emittereinheiten eine gleiche Beschichtung auf. Besonders bevorzugt ist im Falle einer Beschichtung in der zumindest einen Ausnehmung die Reflektivität der zumindest einen Ausnehmung mit der Beschichtung kleiner oder gleich 99,9% und größer oder gleich 80%.

Gemäß einer weiteren Ausführungsform weist für jede Emittereinheit die erste Seitenfläche eine erste Beschichtung auf, die eine Reflektivität für das im aktiven Bereich erzeugte Licht vorgibt. Alternativ oder zusätzlich weist die zweite Seitenfläche eine zweite Beschichtung auf, die eine Reflektivität für das im aktiven Bereich erzeugte Licht vorgibt. Besonders bevorzugt weisen die Emittereinheiten eine gleiche Beschichtung, also eine gleiche erste Beschichtung und/oder eine gleiche zweite Beschichtung, auf.

Gemäß einer weiteren Ausführungsform sind die erste Beschichtung und die zweite Beschichtung gleich. Alternativ hierzu können die erste und zweite Beschichtung auch voneinander verschieden ausgebildet sein.

Sämtliche Merkmale und Ausführungsformen, die in Verbindung mit der ersten Beschichtung beschrieben sind, können auch bei der zweiten Beschichtung ausgebildet sein und umgekehrt. Insbesondere können die vorab und im Folgenden beschriebenen Merkmale und Ausführungsformen für die Beschichtung für alle Emittereinheiten gleich sein, so dass sich die Emittereinheiten bevorzugt nur in der Ausnehmungsbreite unterscheiden.

Die erste Beschichtung und/oder die zweite Beschichtung stellen wie vorab erwähnt mit Vorteil die Reflektivität für das Licht des aktiven Bereiches jeder der Emittereinheiten auf einen vorgegebenen Wert ein. Beispielsweise gibt die erste Beschichtung eine andere Reflektivität für das im aktiven Bereich erzeugte Licht vor als die zweite Beschichtung. Beispielsweise ist die erste Beschichtung niedrigreflektierend ausgebildet, während die zweite Beschichtung hochreflektierend ausgebildet ist. Genauso ist es möglich, dass die erste Beschichtung hochreflektierend ausgebildet ist, während die zweite Beschichtung niedrigreflektierend ausgebildet ist. So kann eine elektrische und/oder optische Isolierung verschiedener Segmente der Emittereinheiten des Halbleiterkörpers voneinander erzielt werden.

Mit dem Begriff "hochreflektierend" ist vorliegend insbesondere gemeint, dass ein so bezeichnetes Element mindestens 20% oder mindesten 40% oder mindestens 50% oder mindesten 80% des im aktiven Bereich erzeugten Lichts reflektiert. Mit dem Begriff "niedrigreflektierend" ist vorliegend insbesondere gemeint, dass ein so bezeichnetes Element höchstens 20% oder höchstens 5% oder höchstens 2% und mindestens 0,1% oder mindestens 1% des im aktiven Bereich erzeugten Lichts reflektiert.

Gemäß einer weiteren Ausführungsform ist die erste Beschichtung als erste Schichtenfolge mit einer Mehrzahl von Einzelschichten ausgebildet. Beispielsweise sind die Einzelschichten aus zwei verschiedenen Materialien gebildet und alternierend angeordnet. Es können auch mehr als zwei verschiedene Materialien für die Einzelschichten verwendet sein. Alternativ oder zusätzlich kann die zweite Beschichtung als zweite Schichtenfolge mit einer Mehrzahl von Einzelschichten ausgebildet sein. Beispielsweise können die Einzelschichten, bezogen auf das im aktiven Bereich erzeugte Licht, eine Dicke von λ/2 oder λ/4 oder Vielfachen davon aufweisen, wobei λ die charakteristische Wellenlänge des im aktiven Bereich erzeugten Lichts bezeichnen kann.

Bevorzugt weist die erste Beschichtung und/oder die zweite Beschichtung ein dielektrisches Material auf oder ist aus einem dielektrischen Material gebildet. Beispielsweise weisen die Einzelschichten ein dielektrisches Material auf oder sind aus einem dielektrischen Material gebildet. Als dielektrische Materialien sind beispielsweise Verbindungen aus der Gruppe der Oxide oder Nitride oder Oxynitride von Al, Ce, Ga, Hf, In, Mg, Nb, Rh, Sb, Si, Sn, Ta, Ti, Zn, Zr geeignet.

Beispielsweise sind die erste Schichtenfolge und die zweite Schichtenfolge aus Einzelschichten gleicher Materialien und mit einer gleichen Abfolge gebildet, wobei eine Dicke der ersten Schichtenfolge im Bereich der ersten Seitenfläche und eine Dicke der zweiten Schichtenfolge im Bereich der zweiten Seitenfläche gleich oder besonders bevorzugt voneinander verschieden ausgebildet sind.

Gemäß einer weiteren Ausführungsform weist die Dicke der ersten Beschichtung im Bereich der ersten Seitenfläche zu einer Dicke der zweiten Beschichtung im Bereich der zweiten Seitenfläche ein Verhältnis zwischen einschließlich 1:1 und einschließlich 1:20, bevorzugt zwischen einschließlich 1:1 und einschließlich 1:10, besonders bevorzugt zwischen einschließlich 1:1,5 und einschließlich 1:4,5 auf.

Gemäß einer weiteren Ausführungsform weist die Dicke der zweiten Beschichtung im Bereich der zweiten Seitenfläche zu einer Dicke der ersten Beschichtung im Bereich der ersten Seitenfläche ein Verhältnis zwischen einschließlich 1:1 und einschließlich 1:20, bevorzugt zwischen einschließlich 1:1 und einschließlich 1:10, besonders bevorzugt zwischen einschließlich 1:1,5 und einschließlich 1:4,5 auf.

Gemäß einer weiteren Ausführungsform ist die zweite Schichtenfolge bis auf eine zusätzliche Symmetriebruchschicht gleichartig zur ersten Schichtenfolge ausgebildet. Bei der Symmetriebruchschicht kann es sich um eine Einzelschicht oder eine Schichtenfolge handeln. Alternativ ist es auch möglich, dass die erste Schichtenfolge bis auf eine zusätzliche Symmetriebruchschicht gleichartig zur zweiten Schichtenfolge ausgebildet ist. Insbesondere führt eine verschiedenartige Ausbildung der ersten Schichtenfolge und der zweiten Schichtenfolge, beispielsweise durch Aufnahme einer Symmetriebruchschicht und insbesondere einer Symmetriebruchschichtenfolge in eine der beiden Schichtenfolgen, zu unterschiedlichen optischen Eigenschaften der ersten Beschichtung und der zweiten Beschichtung.

Beispielsweise füllen die erste Beschichtung und die zweite Beschichtung für jede Emittereinheit die zumindest eine Ausnehmung vollständig aus. Weiterhin ist es auch möglich, dass zwischen der ersten Beschichtung und der zweiten Beschichtung ein Bereich der Ausnehmung frei von der ersten Beschichtung und der zweiten Beschichtung bleibt. Der Bereich der Ausnehmung, der frei bleibt von der ersten Beschichtung und der zweiten Beschichtung, kann mit einem weiteren Material gefüllt sein, das auch als Füllung bezeichnet werden kann und das bevorzugt mit oder aus einem Dielektrikum wie Siliziumdioxid, Titandioxid, Siliziumnitrid gebildet wird. So kann ein Verlust von Licht aufgrund großer Brechungsindexunterschiede zwischen Halbleitermaterial und Dielektrikum bei der Lichtkopplung zwischen den durch die zumindest eine Ausnehmung getrennten Bereichen zumindest verringert werden.

Gemäß einer weiteren Ausführungsform weist der Licht emittierende Halbleiterchip einen Halbleiterkörper mit einer Mehrzahl von Emittereinheiten auf, die jeweils mit einem ersten Segment und einem zweiten Segment ausgebildet sind, wobei das erste Segment vom zweiten Segment durch die zumindest eine Ausnehmung elektrisch und/oder optisch isoliert ist. Insbesondere können die Emittereinheiten in Bezug auf die Segmente gleich ausgebildet sein.

Das erste Segment und das zweite Segment weisen beispielsweise unterschiedliche Funktionalitäten auf. Weiterhin ist es auch möglich, dass mehrere Segmente einer Emittereinheit die gleiche Funktionalität aufweisen. Das erste Segment und das zweite Segment sind besonders bevorzugt entlang der Abstrahlrichtung der jeweiligen Emittereinheit angeordnet. Beispielsweise ist auf dem ersten Segment eine erste Kontaktstelle aufgebracht und auf dem zweiten Segment eine zweite Kontaktstelle. Die beiden Kontaktstellen sind dazu eingerichtet, die beiden Segmente unabhängig voneinander elektrisch zu kontaktieren.

Jede der Emittereinheiten kann auch mehr als zwei Segmente aufweisen. Im Folgenden wird im Detail der Einfachheit halber lediglich auf eine Emittereinheit mit zwei Segmenten eingegangen. Alle Ausführungsformen und Merkmale, die in Verbindung mit dem ersten und dem zweiten Segment offenbart sind, können auch bei weiteren Segmenten sowie insbesondere für alle Emittereinheiten ausgebildet sein. Je nach Funktionalität der Segmente kann bei jeder Emittereinheit zumindest eine Ausnehmung im Bereich der Rückseite und/oder zumindest eine Ausnehmung im Bereich der Auskoppelseite angeordnet sein.

Gemäß einer weiteren Ausführungsform weist das erste Segment den Licht erzeugenden Teil und das zweite Segment ein Modulationselement auf, das dazu eingerichtet ist, eine Intensität des im aktiven Bereich erzeugten Lichts zu modulieren. Beispielsweise wird im ersten Segment Licht erzeugt, bevorzugt Laserlicht, das durch die zumindest eine Ausnehmung in das Modulationselement eintritt. Das Modulationselement kann durch eine Variation in der Bestromung, insbesondere durch eine elektrische Ansteuerung inklusive Rückwärtsspannung und Vorwärtsstrom, über die zweite Kontaktstelle durchlässig bis hin zu absorbierend für das Licht eingestellt werden. Ist das Modulationselement absorbierend für das Licht aus dem Licht erzeugenden Teil ausgebildet, so ist das Modulationselement als Absorberelement ausgebildet.

Gemäß einer weiteren Ausführungsform sind das erste Segment und das zweite Segment elektrisch voneinander getrennt und das zweite Segment weist ein elektrisches Schaltelement auf, das dazu eingerichtet ist, die Emittereinheit einzuschalten und auszuschalten.

Gemäß einer weiteren Ausführungsform weisen zumindest eine oder mehrere oder alle Emittereinheiten ein Segment mit einem oder mehreren der folgenden Elemente auf: Fotodiode, passiver Wellenleiter, aktiver Wellenleiter, Strahlteiler, Strahlkombinierer, Linse, wellenlängenselektives Element, Phasenschiebeelemente, Frequenzverdoppler, Taper, Verstärker, Konverter, Transistor.

Alternativ zu einer Ausbildung als Laserlichtquelle können die Emittereinheiten beispielsweise auch als Superlumineszenzdiode ausgebildet sein, bei der zwar eine Verstärkung des im aktiven Bereich erzeugten Lichts innerhalb eines Resonators stattfindet, jedoch kein vollständiger Laserbetrieb erzielt wird.

Gemäß einer weiteren Ausführungsform wird beispielsweise durch Aufwachsen ein Halbleiterkörper bereitgestellt, der eine aktive Schicht mit einer Mehrzahl von aktiven Bereichen umfasst, die dazu eingerichtet und vorgesehen sind, im Betrieb Licht zu erzeugen, und die in einem Resonator angeordnet sind. Jeder der aktiven Bereiche ist einer Emittereinheit zugeordnet, so dass der Halbleiterkörper eine Mehrzahl von monolithisch integrierten Emittereinheiten aufweist, von denen jede einen aktiven Bereich aufweist.

Weiterhin wird in jeder der Emittereinheiten zumindest eine Ausnehmung im Halbleiterkörper erzeugt, wobei bei jeder der Emittereinheiten die zumindest eine Ausnehmung den jeweiligen aktiven Bereich vollständig durchdringt. Bei jeder Emittereinheit weist die zumindest eine Ausnehmung eine erste Seitenfläche und eine zweite Seitenfläche auf, wobei die erste Seitenfläche gegenüber der zweiten Seitenfläche angeordnet ist. Beispielsweise wird bei jeder Emittereinheit die zumindest eine Ausnehmung durch Ätzen erzeugt. Wie vorab beschrieben weist bei jeder der Emittereinheiten die zumindest eine Ausnehmung eine Ausnehmungsbreite in Abstrahlrichtung auf, was besonders bevorzugt einem Abstand der ersten und zweiten Seitenflächen zueinander in Abstrahlrichtung entsprechen kann. Die Emittereinheiten werden derart hergestellt, dass sich die Ausnehmungsbreiten unterscheiden. Besonders bevorzugt kann dies sowohl im Fall, dass jede Emittereinheit eine eigens zugeordnete Ausnehmung aufweist, als auch im Fall, dass sich eine Ausnehmung durch die aktiven Bereiche mehrerer Emittereinheiten erstreckt, in einem gemeinsamen Verfahrensschritt erzeugt werden.

Gemäß einer weiteren Ausführungsform wird für jede Emittereinheit, besonders bevorzugt in einem gemeinsamen Verfahrensschritt, eine Beschichtung aufgebracht, etwa eine erste Beschichtung auf die erste Seitenfläche und/oder eine zweite Beschichtung auf die zweite Seitenfläche.

Beispielsweise kann es auch sein, dass für jede Emittereinheit die zweite Seitenfläche der zumindest einen Ausnehmung mit einer Schutzschicht versehen wird. In einem nächsten Schritt können für jede Emittereinheit die erste Seitenfläche der zumindest einen Ausnehmung mit der ersten Beschichtung versehen und die Schutzschicht wieder entfernt werden, sodass der Halbleiterkörper im Bereich der zweiten Seitenfläche jeweils frei zugänglich ist. Als Schutzschicht kann beispielsweise eine Fotolackschicht verwendet werden.

Beispielsweise können die erste Beschichtung und/oder die zweite Beschichtung beispielsweise mittels Aufdampfen, Sputtern, Atomlagenabscheidung ("atomic layer deposition", ALD-Verfahren) oder chemischer Gasphasenabscheidung ("chemical vapor deposition", CVD-Verfahren) abgeschieden werden.

Beim Aufdampfen und beim Sputtern wird die zu beschichtende Oberfläche in einem Volumen bereitgestellt. In dem Volumen wird weiterhin zumindest ein Ausgangsmaterial in der Gasphase bereitgestellt. Das Ausgangsmaterial kondensiert direkt auf der Oberfläche und bildet so eine Beschichtung auf der Oberfläche aus. Beim Aufdampfen wird das Ausgangsmaterial durch Temperaturbeaufschlagung in die Gasphase übergeführt, während das Ausgangsmaterial beim Sputtern durch Ionenbeschuss in die Gasphase übergeführt wird. Aufdampfen und Sputtern sind in der Regel gerichtete Abscheideverfahren, bei dem entlang einer Vorzugsrichtung mehr Material abgeschieden wird als entlang der anderen Richtungen.

Beim CVD-Verfahren wird ebenfalls die zu beschichtende Oberfläche in einem Volumen zur Verfügung gestellt. In dem Volumen wird weiterhin zumindest ein Ausgangsmaterial zur Verfügung gestellt, aus dem durch eine chemische Reaktion an der zu beschichtenden Oberfläche eine feste Beschichtung abgeschieden wird. In der Regel befindet sich in dem Volumen zumindest ein zweites Ausgangsmaterial, mit dem das erste Ausgangsmaterial unter Bildung der festen Beschichtung an der Oberfläche chemisch reagiert. Das CVD-Verfahren zeichnet sich somit durch mindestens eine chemische Reaktion an der zu beschichtenden Oberfläche zur Bildung der CVD-Schicht aus. Bei der chemischen Gasphasenabscheidung können auch mehr als zwei Ausgangsmaterialien zum Einsatz kommen.

Mit Atomlagenabscheidung ist vorliegend ein Verfahren bezeichnet, bei dem das erste gasförmige Ausgangsmaterial dem Volumen zugeführt wird, in dem die zu beschichtende Oberfläche bereitgestellt ist, sodass das erste gasförmige Ausgangsmaterial auf der Oberfläche adsorbiert. Nach einer bevorzugt vollständigen oder nahezu vollständigen Bedeckung der Oberfläche mit dem ersten Ausgangsmaterial wird der Teil des ersten Ausgangsmaterials, der noch gasförmig beziehungsweise nicht auf der Oberfläche adsorbiert vorliegt, in der Regel wieder aus dem Volumen entfernt und das zweite Ausgangsmaterial wird zugeführt. Das zweite Ausgangsmaterial ist dafür vorgesehen, mit der an der Oberfläche adsorbierten, ersten Ausgangsverbindung unter Bildung einer festen Beschichtung chemisch zu reagieren.

Das CVD-Verfahren und das ALD-Verfahren sind in der Regel ungerichtete oder auch sogenannte isotrope Abscheideverfahren, bei denen das Material gleichmäßig entlang aller Richtungen abgeschieden wird.

Weiterhin kann es sein, dass die erste Beschichtung zumindest im Bereich der ersten Seitenfläche mit einer weiteren Schutzschicht versehen wird. Dieser Schritt erfolgt in der Regel nach dem Aufbringen der ersten Beschichtung auf die erste Seitenfläche. Die zweite Seitenfläche bleibt besonders bevorzugt frei von der Schutzschicht.

Weiterhin können die zweite Seitenfläche mit der zweiten Beschichtung versehen und die weitere Schutzschicht wieder entfernt werden, sodass die erste Beschichtung im Bereich der ersten Seitenfläche frei zugänglich ist. Dies erfolgt bevorzugt nach dem Aufbringen der zweiten Beschichtung. Mit Hilfe der beiden Schutzschichten können mit Vorteil zwei Beschichtungen erzeugt werden, die verschieden voneinander sind.

Wie oben beschrieben ist, können die erste Beschichtung und die zweite Beschichtung in zeitlich nacheinander ausgeführten Schritten auf die erste Seitenfläche und die zweite Seitenfläche aufgebracht werden.

Gemäß einer weiteren Ausführungsform werden die erste Beschichtung und die zweite Beschichtung gleichzeitig auf die erste Seitenfläche und die zweite Seitenfläche aufgebracht. Bei dieser Ausführungsform des Verfahrens ist die erste Beschichtung bevorzugt als erste Schichtenfolge einer Mehrzahl von Einzelschichten ausgebildet und die zweite Beschichtung als zweite Schichtenfolge einer Mehrzahl von zweiten Einzelschichten. Besonders bevorzugt weisen die erste Schichtenfolge und die zweite Schichtenfolge bei dieser Ausführungsform des Verfahrens Einzelschichten gleicher Materialien und gleicher Abfolge auf. Besonders bevorzugt unterscheiden sich die erste Schichtenfolge und die zweite Schichtenfolge jedoch in ihren Dicken. Bevorzugt weist eine Dicke der ersten Schichtenfolge im Bereich der ersten Seitenfläche zu einer Dicke der zweiten Schichtenfolge im Bereich der zweiten Seitenfläche ein Verhältnis zwischen einschließlich 1:1 und einschließlich 1:20 auf, bevorzugt zwischen einschließlich 1:1 und einschließlich 1:10, besonders bevorzugt zwischen einschließlich 1:1,5 und einschließlich 1:4,5.

Um derartige Beschichtungen zu erzeugen, wird bevorzugt ein Verfahren zur Abscheidung verwendet, bei dem eine Vorzugsrichtung zur Aufbringung der ersten Beschichtung und der zweiten Beschichtung einen vorgegebenen Winkel mit einer Haupterstreckungsebene des Halbleiterkörpers einschließt. Bevorzugt ist der Winkel ungleich 90°. So lassen sich eine erste Beschichtung und eine zweite Beschichtung erzielen, deren Dicke, auf der ersten Seitenfläche und der zweiten Seitenfläche verschieden voneinander sind, aber die gleichen Materialien und Abfolgen an Einzelschichten aufweisen. Mit anderen Worten wird hierbei besonders bevorzugt ein gerichtetes Abscheideverfahren, wie thermisches Verdampfen oder Sputtern verwendet.

Gemäß einer weiteren Ausführungsform wird vor dem Aufbringen der ersten Beschichtung und der zweiten Beschichtung ein Abschattungselement auf einen Bereich einer Hauptfläche des Halbleiterkörpers, der für jede Emittereinheit direkt an die erste Seitenfläche der zumindest einen Ausnehmung angrenzt, aufgebracht, sodass die Dicke der ersten Beschichtung im Bereich der ersten Seitenfläche von der Dicke der zweiten Beschichtung im Bereich der zweiten Seitenfläche verschieden ist. Auch mit Hilfe eines Abschattungselements können somit eine erste Beschichtung und eine zweite Beschichtung gleichzeitig auf die Seitenflächen aufgebracht werden, die zumindest im Bereich der ersten Seitenfläche und der zweiten Seitenfläche verschiedene Dicken aufweisen.

Gemäß einer weiteren Ausführungsform ist die erste Beschichtung als erste Schichtenfolge mit einer Mehrzahl von Einzelschichten ausgebildet. Gemäß einer weiteren Ausführungsform des Verfahrens ist die zweite Beschichtung als zweite Schichtenfolge mit einer Mehrzahl von Einzelschichten ausgebildet.

Die zumindest eine Ausnehmung kann für jede Emittereinheit im Bereich der Rückseite oder im Bereich der Auskoppelseite angeordnet werden. Im Bereich der Rückseite kann insbesondere bedeuten, dass die zumindest eine Ausnehmung entlang der Abstrahlrichtung näher an der Rückseite als an der Auskoppelseite angeordnet wird. Im Bereich der Auskoppelseite kann insbesondere bedeuten, dass die zumindest eine Ausnehmung entlang der Abstrahlrichtung näher an der Auskoppelseite als an der Rückseite angeordnet wird.

In einer bevorzugten Ausführungsform wird die zumindest eine Ausnehmung bei jeder Emittereinheit bevorzugt im Bereich der Rückseite des Resonators ausgebildet, sodass die Rückseitenreflektivität moduliert werden kann. Durch eine gezielte Beschichtung, die vorteilhaft bereits im Waferverbund aufgebracht werden kann, wird die passende Reflektivität und Modulation je nach Ausnehmungsbreite erzeugt. Dadurch, dass die zumindest eine Ausnehmung im Bereich der Rückseite ausgebildet ist, muss das auf der Auskoppelseite ausgekoppelte Licht nicht durch die zumindest eine Ausnehmung propagieren, wodurch sich eine bessere Stahlqualität ergibt.

Alternativ oder zusätzlich kann bei jeder Emittereinheit zumindest eine Ausnehmung auch im Bereich der Auskoppelseite ausgebildet werden, wobei sich ebenfalls eine Abhängigkeit von der Ausnehmungsbreite ergibt. Dies kann insbesondere bei Multisektions-Bauelementen vorteilhaft sein, während die Ausführung auf der Rückseite auch bei "einfachen" Laserresonatoren möglich ist.

Weiterhin ist auch eine Ausbildung zumindest einer Ausnehmung im Bereich der Rückseite und zumindest einer Ausnehmung im Bereich der Auskoppelseite bei jeder Emittereinheit möglich, um den Modulationseffekt zu verstärken oder um noch schmalere Reflexionsmaxima zu erreichen. Da die Maxima des Reflexionsspektrums eine gewisse spektrale Breite haben, lässt sich durch zwei leicht gegeneinander verschobene Spektren im Bereich der Rückseite und im Bereich der Auskoppelseite ein deutlich schmaleres Wellenlängenfenster erzielen, in dem die Emittereinheiten emittieren müssen. Vorteilhafterweise ist die Funktionsweise nicht abhängig von der absoluten Ausnehmungsbreite bei den Emittereinheiten, sondern nur von den relativen Ausnehmungsbreitenunterschieden zwischen den Emittereinheiten, da sich die Modulation periodisch mit der Ausnehmungsbreite wiederholt. Dadurch sind Produktionsschwankungen bei der Ausnehmungsbreite unkritisch und diese Lösung ist technisch sehr einfach zu realisieren.

Bei dem hier beschriebenen Licht emittierenden Halbleiterchip kann es somit möglich sein, eine Variation der Wellenlänge über die einzelnen Emittereinheiten eines Licht emittierenden Halbleiterchips mit definierter Verschiebung zu erreichen, die die Betriebsparameter annähernd gleich lässt. Eine solche Lösung kann außerdem für spezielle Bauteile wie beispielsweise Mehrsegment-Laser anwendbar sein, da durch die Ausbildung mehrerer Segmente die Funktionalität der Emittereinheiten bezüglich optimaler Verwendbarkeit in optischen Geräten erweitern kann. Beispielsweise kann ein Licht emittierender Halbleiterchip mit Emittereinheiten jeweils mit einer Verstärker-Sektion und einer Modulator-Sektion ausgebildet werden, um die Lichtleistung auch für niedrige Ausgangsleistungen stufenlos regeln zu können, was für kontrastreiche Darstellungen sehr vorteilhaft sein kann.

Der hier beschriebene Licht emittierende Halbleiterchip kann beispielsweise in einer der folgenden Anwendungen verwendet werden: Augmented Reality, Virtual Reality, Pico-Projection, LIDAR ("light detection and ranging", Lichtdetektion und Abstandmessung), Nachrichtenübertragung.

Bei dem hier beschriebenen Licht emittierenden Halbleiterchip ist es insbesondere möglich, auf einfache Weise verschiedene Wellenlängen bei nebeneinander liegenden Emittereinheiten zu realisieren, was anderweitig nur schwer zu erreichen wäre. Die Einfachheit des Prozesses erlaubt eine kostengünstige Produktion. Durch die verschiedenen Wellenlängen kann eine deutlich verbesserte Bildqualität beispielsweise bei AR/VR-Anwendungen erreicht werden. Das beschriebene Verfahren ist unempfindlich gegen Prozessschwankungen, sodass hohe und stabile Herstellungsausbeuten erreichbar sein können. Eine In-Situ-Kontrolle ist aufgrund der Stabilität gegen Prozessschwankungen nicht nötig, wodurch Kosten gespart werden können.

Weitere Vorteile, vorteilhafte Ausführungsformen und Weiterbildungen ergeben sich aus den im Folgenden in Verbindung mit den Figuren beschriebenen Ausführungsbeispielen.

Die Figuren 1A bis 1E zeigen schematische Darstellungen eines Licht emittierenden Halbleiterchips sowie verschiedener Stadien eines Verfahrens zur Herstellung des Licht emittierenden Halbleiterchips und ein beispielhaftes Emissionsspektrum gemäß einem Ausführungsbeispiel.

Die Figuren 2A und 2B zeigen schematische Darstellungen von Teilen von Licht emittierenden Halbleiterchips gemäß weiteren Ausführungsbeispielen.

Die Figuren 3A bis 3D zeigen Simulationen der Reflektivität R in Abhängigkeit von der Wellenlänge λ für eine Beschichtung gemäß einem Ausführungsbeispiel.

Die Figuren 4A und 4B zeigen Simulationen der Reflektivität R und der Spiegelverluste L in Abhängigkeit von der Wellenlänge λ für eine Beschichtung gemäß einem Ausführungsbeispiel.

Die Figuren 5A und 5B zeigen eine schematische Darstellung eines Teils eines Licht emittierenden Halbleiterchips und eine Simulation der Reflektivität R in Abhängigkeit von der Wellenlänge λ für eine Beschichtung gemäß einem Ausführungsbeispiel.

Die Figuren 6A und 6B zeigen schematische Darstellungen eines Licht emittierenden Halbleiterchips gemäß einem weiteren Ausführungsbeispiel.

Die Figuren 7A und 7B zeigen schematische Darstellungen eines Licht emittierenden Halbleiterchips gemäß einem weiteren Ausführungsbeispiel.

Die Figuren 8A und 8B zeigen schematische Darstellungen eines Licht emittierenden Halbleiterchips gemäß einem weiteren Ausführungsbeispiel.

Die Figuren 9A und 9B zeigen Simulationen der Reflektivität R in Abhängigkeit von der Wellenlänge λ für Beschichtungen gemäß weiteren Ausführungsbeispielen.

Die Figuren 10A bis 10C zeigen eine schematische Darstellung eines Teils eines Licht emittierenden Halbleiterchips sowie Simulationen der Reflektivität R in Abhängigkeit von der Wellenlänge λ für Beschichtungen gemäß weiteren Ausführungsbeispielen.

Die Figuren 11A bis 11C zeigen Simulationen der Reflektivität R in Abhängigkeit von der Wellenlänge λ für Beschichtungen gemäß weiteren Ausführungsbeispielen.

Die Figuren 12A bis 12E zeigen Simulationen der Reflektivität R und des Gains G in Abhängigkeit von der Wellenlänge λ sowie von spektralen Parametern in Abhängigkeit von der Ausnehmungsbreite A für eine Beschichtung gemäß einem weiteren Ausführungsbeispiel.

Die Figuren 13A bis 19C zeigen schematische Darstellungen von Licht emittierenden Halbleiterchips und von Teilen solcher gemäß weiteren Ausführungsbeispielen.

In den Ausführungsbeispielen und Figuren können gleiche, gleichartige oder gleich wirkende Elemente jeweils mit denselben Bezugszeichen versehen sein. Die dargestellten Elemente und deren Größenverhältnisse untereinander sind nicht als maßstabsgerecht anzusehen, vielmehr können einzelne Elemente, wie zum Beispiel Schichten, Bauteile, Bauelemente und Bereiche, zur besseren Darstellbarkeit und/oder zum besseren Verständnis übertrieben groß dargestellt sein.

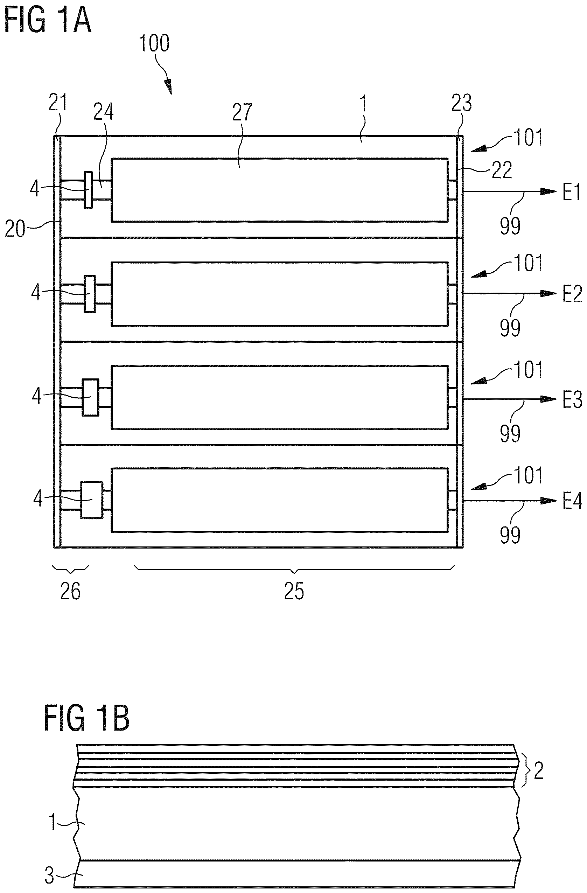

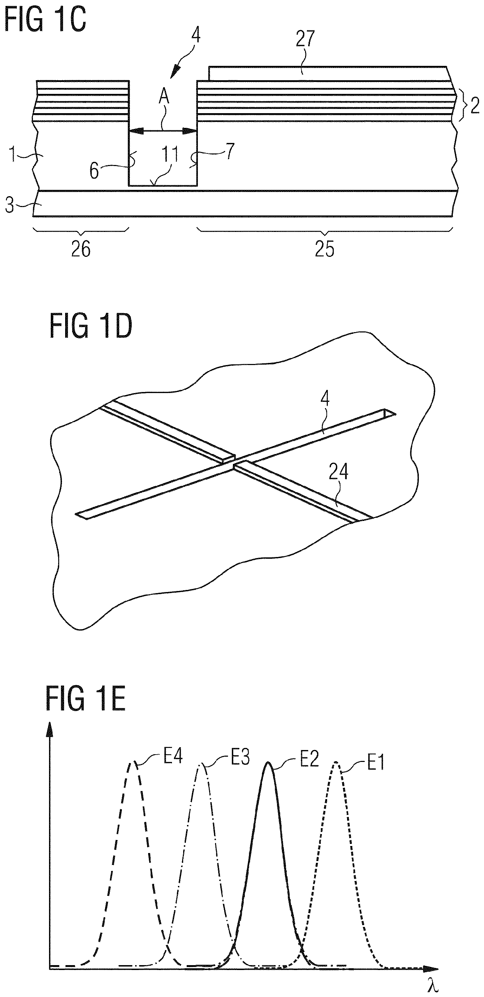

In Verbindung mit den Figuren 1A bis 1E sind ein Ausführungsbeispiel für einen Licht emittierenden Halbleiterchip 100 und Verfahrensschritte zur Herstellung dessen dargestellt. Figur 1A zeigt eine Aufsicht auf den Licht emittierenden Halbleiterchip 100. Die Figuren 1B bis 1D zeigen Verfahrensschritte anhand von Ausschnitten und die Figur 1E zeigt ein beispielhaftes Emissionsspektrum des Licht emittierenden Halbleiterchips 100. Die nachfolgende Beschreibung bezieht sich gleichermaßen auf die Figuren 1A bis 1E.

Der Licht emittierende Halbleiterchip 100, der insbesondere als Multi-Emitter-Laserlichtquelle ausgebildet ist, weist einen Halbleiterkörper 1 auf, der eine Mehrzahl von Emittereinheiten 101 aufweist. Rein beispielhaft sind in Figur 1A vier Emittereinheiten 101 angedeutet, die jeweils einen aktiven Bereich 2 aufweisen, in dem im Betrieb Licht erzeugt wird, das von den Emittereinheiten 101 über eine Auskoppelseite 22 entlang der angedeuteten Abstrahlrichtungen 99 abgestrahlt wird. Der Licht emittierende Halbleiterchip 100 kann auch mehr oder weniger Emittereinheiten 101 aufweisen.

Der Halbleiterkörper 1 ist als Halbleiterschichtenfolge auf einem Substrat 3 aufgebracht. Beispielsweise kann der Halbleiterkörper 1 wie im allgemeinen Teil beschrieben auf dem Substrat 3 aufgewachsen werden und ein im allgemeinen Teil beschriebenes Material aufweisen. Die Halbleiterschichtenfolge und insbesondere der aktive Bereich 2, der beispielsweise eine oder wie in den Figuren angedeutet mehrere Schichten aufweisen kann, können wie im allgemeinen Teil ausgebildet sein. Der Übersichtlichkeit halber sind in den Figuren abgesehen vom aktiven Bereich 2 keine weiteren Einzelschichten des Halbleiterkörpers 1 angedeutet.

Der aktive Bereich 2 jeder der zumindest einen Emittereinheit 10 ist in einem Resonator angeordnet. Der Resonator ist insbesondere dazu ausgebildet, das Licht, das im aktiven Bereich 2 erzeugt wird, zu verstärken. Beispielsweise durch den Resonator sowie durch eine beispielhaft vorhandene Stegwellenleiterstruktur 24, die auch als Ridge bezeichnet werden kann, kann die Abstrahlrichtung 99 definiert sein, entlang derer von einer Emittereinheit 101 im Betrieb Licht emittiert wird. Im gezeigten Ausführungsbeispiel wird der Resonator durch eine erste Schicht 21 auf einer Rückseite und eine zweite Schicht 23 auf der Auskoppelseite 22 begrenzt, wobei die Rückseite 20 und die Auskoppelseite 22 Seitenflächen des Halbleiterkörpers 1 sind. Beispielsweise kann die erste Schicht 21 eine Schicht oder Schichtenfolge sein, die die Rückseite 20 teil- oder vollverspiegelt, während die zweite Schicht 23 eine Schicht oder Schichtenfolge sein kann, die die Auskoppelseite 22 teilverspiegelt.

Im Halbleiterkörper 1 wird für jede Emittereinheit 101 eine Ausnehmung 4 erzeugt, die den jeweiligen aktiven Bereich 2 vollständig durchdringt. Im gezeigten Ausführungsbeispiel weist jede Emittereinheit 101 eine eigens zugeordnete Ausnehmung 4 auf, die von den Ausnehmungen 4 der jeweils anderen Emittereinheiten 101 getrennt ist. Die Ausnehmungen 4 können den Halbleiterkörper 1 vollständig oder, wie in den Figuren angedeutet ist, teilweise durchdringen. Insbesondere können die Ausnehmungen 4 in eine Halbleiterschicht des Halbleiterkörpers 1 unterhalb des aktiven Bereichs 2 reichen, beispielsweise in eine Wellenleiterschicht, eine Mantelschicht oder eine Pufferschicht.

Die Ausnehmungen 4 weisen jeweils eine erste Seitenfläche 6 und eine zweite Seitenfläche 7, die der ersten Seitenfläche 6 gegenüber liegt, sowie eine Bodenfläche 11 auf. Die Ausnehmungen 4 werden beispielsweise durch Ätzen wie etwa Plasmaätzen und/oder nasschemisches Ätzen in einem gemeinsamen masken- und fotobasierten Prozess erzeugt. Hierzu können im Halbleiterkörper 1 eine oder mehrere Ätzstoppschichten vorhanden sein, die einen Ätzvorgang der Ausnehmungen 4 stoppen und somit die Bodenfläche 11 definieren können. So kann eine Tiefe der Ausnehmungen 4 festgelegt werden. Der in Figur 1C in einer Teilansicht einer Schnittdarstellung durch den Licht emittierenden Halbleiterchip 101 angedeutete Querschnitt einer der Ausnehmungen 4 mit senkrechten Seitenwänden 6, 7 ist rein beispielhaft zu verstehen. Die Form der Seitenwände kann je nach Ätzverfahren von der gezeigten Form abweichen.

Der aktive Bereich 2 einer jeden Emittereinheit 101 ist somit durch eine Ausnehmung 4 unterbrochen. Die jeweilige Ausnehmung 4 ist beispielsweise als Spalt oder Schlitz ausgebildet und weist besonders bevorzugt eine Haupterstreckungsrichtung auf, die nicht-parallel und bevorzugt senkrecht zur Abstrahlrichtung 99 ist, wie in Figur 1D in einem dreidimensionalen Ausschnitt angedeutet ist. Die erste und zweite Seitenfläche 6, 7 sind insbesondere in Abstrahlrichtung 99 hintereinander angeordnet und sind somit für jede Emittereinheit 101 diejenigen Seitenflächen der jeweiligen Ausnehmung 4, durch die die Ausnehmung 4 entlang der Abstrahlrichtung 99 begrenzt ist. Beispielsweise weisen die Ausnehmungen 4 wie gezeigt eine rechteckige Grundfläche auf. Hierbei verlaufen die erste Seitenfläche 6 und die zweite Seitenfläche 7 parallel zur Haupterstreckungsrichtung der jeweiligen Ausnehmung 4. Weiterhin können die Ausnehmungen 4, wie weiter unten gezeigt ist, beispielsweise eine keilförmige und/oder eine zumindest teilweise abgerundete Grundfläche aufweisen. Hierzu kann zumindest eine der ersten und zweiten Seitenfläche 6, 7 zumindest teilweise schräg zur Haupterstreckungsrichtung und/oder zumindest teilweise gebogen verlaufen.

Für jede Emittereinheit 101 weist die jeweilige Ausnehmung 4 im Bereich des aktiven Bereichs 2 eine Ausnehmungsbreite A auf, die entlang der Abstrahlrichtung 99 gemessen wird. Insbesondere kann die Ausnehmungsbreite A somit in einer Richtung gemessen werden, die senkrecht oder im Wesentlichen senkrecht zur Haupterstreckungsrichtung der Ausnehmung 4 ist. Bevorzugt ist für jede Emittereinheit 101 die Ausnehmungsbreite A größer oder gleich 100 nm oder größer oder gleich 300 nm oder größer oder gleich 500 nm und kleiner oder gleich 20 µm oder kleiner oder gleich 10 µm oder kleiner oder gleich 5 µm.

Wie in Figur 1A angedeutet ist, sind die Ausnehmungsbreiten A der Emittereinheiten 101 unterschiedlich. Mit anderen Worten weist jede Emittereinheit eine Ausnehmung 4 mit einer Ausnehmungsbreite A auf, wobei die Ausnehmungsbreiten A jeweils paarweise zueinander verschieden sind.

Die Ausnehmungsbreiten A von zumindest zwei oder mehreren oder allen Emittereinheiten 101 können sich jeweils paarweise um einen Betrag unterscheiden, der größer oder gleich 1 nm oder größer oder gleich 2 nm oder größer oder gleich 5 nm oder größer oder gleich 10 nm ist und der kleiner oder gleich 2 µm oder kleiner oder gleich 1 µm oder kleiner oder gleich 500 nm oder kleiner oder gleich 200 nm oder kleiner oder gleich 100 nm oder kleiner oder gleich 90 nm oder kleiner oder gleich 75 nm oder kleiner oder gleich 60 nm oder kleiner oder gleich 50 nm ist. Weiterhin können sich die Ausnehmungsbreiten A der Emittereinheiten 101 um einen Betrag unterscheiden, der größer oder gleich 1% oder größer oder gleich 2% oder größer oder gleich 5% oder größer oder gleich 10% und kleiner oder gleich 25% oder kleiner oder gleich 20% oder größer oder gleich 15% oder kleiner oder gleich 10% der charakteristischen Wellenlänge des in den Emittereinheiten 101 im Betrieb erzeugten Lichts ist.

In einem besonders bevorzugten Ausführungsbeispiel sind die Ausnehmungsbreiten A der Emittereinheiten 101 äquidistant voneinander verschieden. Das bedeutet im gezeigten Ausführungsbeispiel, dass die Differenz zwischen den Ausnehmungsbreiten der in Figur 1A gezeigten beiden obersten Emittereinheiten 101 gleich der Differenz zwischen den Ausnehmungsbreiten der in Figur 1A gezeigten beiden mittleren Emittereinheiten 101 ist, die wiederum gleich der Differenz zwischen den Ausnehmungsbreiten der in Figur 1A gezeigten beiden untersten Emittereinheiten 101 ist.

Durch die jeweilige Ausnehmung 4 im aktiven Bereich 2 jeder Emittereinheit 101 kann eine wellenlängenabhängige Reflektivität erzielt werden, wobei das Reflexionsspektrum von der jeweiligen Ausnehmungsbreite A beeinflusst wird. Durch die Variation der Ausnehmungsbreiten A können die Emittereinheiten dadurch Emissionsspektren E1, E2, E3 und E4 mit unterschiedlichen Emissionswellenlängen abstrahlen, wie beispielhaft in Figur 1E angedeutet ist. Für einen Licht emittierenden Halbleiterchip 100 mit Emissionsspektren im sichtbaren Wellenlängenbereich können die spektralen Abstände der einzelnen Emissionsspektren E1, E2, E3, E4 durch die Variation der Ausnehmungsbreite A größer oder gleich +/-0,5 nm, bevorzugt größer oder gleich +/-1,0 nm und besonders bevorzugt größer oder gleich +/-3 nm betragen.

Für Anwendung in anderen Wellenlängenbereichen, also beispielsweise bei kürzeren Wellenlängen oder im infraroten Spektralbereich, etwa für Infrarot-Bildgebung, Gassensorik oder weitere Anwendungen, in denen verschobene Emissionswellenlängen in einem Multiemitter-Chip relevant sind, skaliert typischerweise der relevante Wellenlängenabstand und die gesamte abzudeckende Wellenlängenbreite mit der Wellenlänge selbst.

Für das vorliegende Ausführungsbeispiel und für alle folgenden Ausführungsbeispiele gilt, dass die spektrale Anpassung der Emittereinheiten durch die Änderung der Schlitzbreite technisch einfach zu realisieren ist und sie die Betriebsparameter quasi nicht beeinflusst.

Für jede Emittereinheit 101 ist die jeweilige Ausnehmung 4 bevorzugt dazu vorgesehen und eingerichtet, verschiedene Segmente 25, 26 der Emittereinheiten 101 des Halbleiterkörpers 1 elektrisch und/oder optisch voneinander zu isolieren. Die Segmente 25, 26 der Emittereinheiten 101 können gleiche oder verschiedene Funktionalitäten aufweisen. In den Figuren 1A und 1C sind zwei Segmente 25, 26 angedeutet, von denen ein erstes Segment 25 mittels einer ersten elektrischen Kontaktstelle 27, beispielsweise in Form einer Elektrodenschicht, elektrisch kontaktiert ist, während das andere, zweite Segment 26 unkontaktiert bleibt. Alternativ können, wie weiter unten beschrieben ist, die Segmente separat kontaktiert werden. Alternativ dazu können die Segmente auch über eine gemeinsame Kontaktstelle kurzgeschlossen werden.

Die Position der Ausnehmung 4 jeder der Emittereinheiten 101 kann an einer beliebiger Stelle der Gesamtresonatorlänge liegen, bevorzugt jedoch im Bereich und insbesondere nahe der Rückseite 20, wie es im vorliegenden Ausführungsbeispiel der Fall ist, oder im Bereich und insbesondere nahe der Auskoppelseite 22, wie weiter unten beschrieben ist.

Durch die Trennung der Kavitäten der Emittereinheiten 101 in zwei Segmente oder, im Fall einer Ausbildung mehrerer Ausnehmungen 4 pro Emittereinheit 101 wie weiter unten gezeigt ist, in mehr als zwei Segmente, können die Segmente für die Einstellung unterschiedlicher Eigenschaften des Licht emittierenden Halbleiterchips 100 ausgebildet werden. Ein nicht elektrisch kontaktiertes und damit passives Segment kann beispielsweise als passiver Modenfilter oder für eine spektrale Aufweitung, beispielsweise bei einer Superlumineszenzdiode, ausgebildet werden. Ein elektrisch separat kontaktiertes und somit aktives Segment kann als Modulator oder Dimmer oder mit einer anderen im allgemeinen Teil beschriebenen Funktionalität ausgebildet werden.

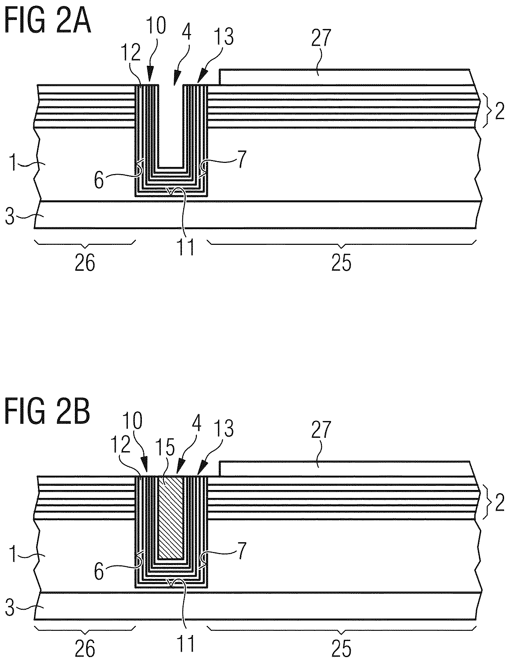

In den Figuren 2A und 2B sind schematische Darstellungen von Teilen von Emittereinheiten von Licht emittierenden Halbleiterchips gemäß weiteren Ausführungsbeispielen gezeigt, die den Ansichten in den Figuren 1B und 1C entsprechen. Im Vergleich zum vorherigen Ausführungsbeispiel weisen die Emittereinheiten gemäß den Ausführungsbeispielen der Figuren 2A und 2B eine Beschichtung in den Ausnehmungen 4 auf, die eine Reflektivität der Ausnehmungen 4 für das im jeweiligen aktiven Bereich 2 erzeugte Licht vorgibt. Mit anderen Worten kann mittels der Beschichtung, die insbesondere mit einer ersten Beschichtung 10 und einer zweiten Beschichtung 13 in Form von einer oder, wie angedeutet, mehreren Schichten 12 ausgebildet wird, eine gewünschte Reflektivität der Ausnehmungen 4 für das im aktiven Bereich 2 erzeugte Licht der jeweiligen Emittereinheit eingestellt werden. Die Reflektivität der Ausnehmung 4 kann für jede Emittereinheit insbesondere so eingestellt werden, dass die jeweilige Ausnehmung 4 entspiegelt, teilverspiegelt oder vollverspiegelt ist. Besonders bevorzugt weisen alle Emittereinheiten des Licht emittierenden Halbleiterchips eine gleiche Beschichtung in der jeweiligen Ausnehmung 4 auf. Besonders bevorzugt ist die Reflektivität der Ausnehmungen 4 mit einer Beschichtung kleiner oder gleich 99,9% und größer oder gleich 80%.

Wie in den Figuren 2A und 2B erkennbar ist, weisen für jede Emittereinheit die erste Seitenfläche 6 eine erste Beschichtung 10 und die zweite Seitenfläche 7 eine zweite Beschichtung 13 auf, die jeweils eine Reflektivität für das im aktiven Bereich 2 erzeugte Licht vorgeben. In den Ausführungsbeispielen der Figuren 2A und 2B sind die erste Beschichtung 10 und die zweite Beschichtung 13 gleich. Alternativ hierzu können die erste und zweite Beschichtung 10, 13 auch voneinander verschieden ausgebildet sein oder es kann nur auf einer der Seitenflächen 6, 7 eine Beschichtung vorhanden sein.

Bevorzugt weist die erste Beschichtung 10 und/oder die zweite Beschichtung 13 ein dielektrisches Material auf oder ist aus einem dielektrischen Material gebildet. Beispielsweise weisen die Einzelschichten 12 ein dielektrisches Material auf oder sind aus einem dielektrischen Material gebildet. Als dielektrische Materialien sind beispielsweise Verbindungen aus der Gruppe der Oxide oder Nitride oder Oxynitride von Al, Ce, Ga, Hf, In, Mg, Nb, Rh, Sb, Si, Sn, Ta, Ti, Zn, Zr geeignet. Die Dicken der Einzuschichten 12 können beispielsweise derart gewählt sein, dass sie eine Dicke von λ/2 oder λ/4 oder Vielfachen davon aufweisen, wobei λ die charakteristische Wellenlänge des im aktiven Bereich 2 erzeugten Lichts bezeichnet.

Beispielsweise füllen die erste Beschichtung 10 und die zweite Beschichtung 13 für jede Emittereinheit die jeweilige Ausnehmung 4 vollständig aus. Weiterhin ist es auch möglich, dass zwischen der ersten Beschichtung 10 und der zweiten Beschichtung 13 ein Bereich der Ausnehmung 4 frei von der ersten Beschichtung 10 und der zweiten Beschichtung 13 bleibt, wie in Figur 2A angedeutet ist. Der Bereich der Ausnehmung 4, der frei bleibt von der ersten Beschichtung 10 und der zweiten Beschichtung 13, kann weiterhin, wie in Figur 2B angedeutet ist, mit einem weiteren Material gefüllt sein, das als Füllung 15 bezeichnet werden kann und das bevorzugt mit oder aus einem Dielektrikum wie Siliziumdioxid, Titandioxid, Siliziumnitrid gebildet wird. Weiterhin kann die Füllung 15 eines oder mehrere Materialien aufweisen, die vorab in Verbindung mit der ersten und zweiten Beschichtung beschrieben sind. So kann ein Verlust von Licht aufgrund großer Brechungsindexunterschiede zwischen Halbleitermaterial und Dielektrikum bei der Lichtkopplung zwischen den durch die zumindest eine Ausnehmung 4 getrennten Segmenten zumindest verringert werden. Besonders bevorzugt wird durch die Füllung 15 der Teil der Ausnehmung 4 gefüllt, der nicht durch die erste und zweite Beschichtung 10, 13 gefüllt ist, so dass die Ausnehmung 4 vollständig gefüllt ist.

In den Ausführungsbeispielen der Figuren 1A bis 2B sind die Ausnehmungen 4 mit unterschiedlicher Ausnehmungsbreite im Bereich der Rückseite eingebracht. Die Ausnehmungen 4 sind bevorzugt mit Schichten zumindest teilweise gefüllt, die den Ausnehmungen 4 hochreflektierende Eigenschaften geben, und weisen die vorab beschriebenen unterschiedlichen Ausnehmungsbreiten auf.

Die Rückseite weist bevorzugt eine Beschichtung mit der vorab beschriebenen ersten Schicht auf, die beispielsweise eine sehr niedrige Reflektivität aufweist, sodass Rückreflexionen in den Resonator vermieden werden können. Die beschichteten Ausnehmungen 4 selbst können somit als hochreflektierende Facette dienen. Dadurch, dass die zweiten Segmente 26 links von den Ausnehmungen 4 nicht elektrisch kontaktiert und somit passiv sind, sind diese sozusagen nur ein "Anhängsel" und haben durch die beschriebene Entspiegelungsbeschichtung keinen Einfluss mehr auf die Reflektivität. Alternativ hierzu kann es aber auch möglich sein, die erste Schicht auf der Rückseite auch als Rückseitenspiegel mit wenigstens teilweiser Reflektivität mit zu nutzen.

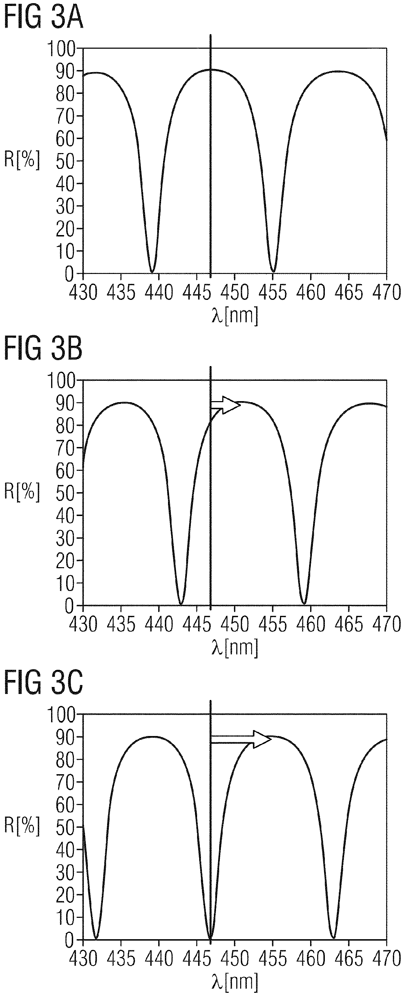

Wird die Ausnehmung 4 mit Schichtpaaren mit zumindest näherungsweise als λ/4-Schichten ausgebildeten Einzelschichten 12 gefüllt, lassen sich hochreflektierende Spiegel mit starker Modulation herstellen. In den Figuren 3A bis 3D sind Simulationen der Reflektivität R in Abhängigkeit von der Wellenlänge λ für eine Beschichtung 10, 13 mit der in Tabelle 1 angegebenen Zusammensetzung dargestellt.

Die in der Tabelle 1 sowie in den weiteren Tabellen angegebenen Materialien sind rein beispielhaft zu verstehen, um die zugrunde liegenden Prinzipien zu erläutern. Alternativ oder zusätzlich können auch andere der genannten Materialien verwendbar. Insbesondere können die Zusammensetzungen der Materialien auch von einer stöchiometrischen Zusammensetzung abweichen. Die in der Tabelle 1 und den folgenden Tabellen angegebene Reihenfolge der Materialien von oben nach unten entspricht einer Reihenfolge entlang der Abstrahlrichtung von der ersten Seitenfläche zur zweiten Seitenfläche der Ausnehmung, wobei die Seitenflächen durch den Halbleiterkörper gebildet werden, der in den Tabellen daher am Anfang und am Ende mit angegeben ist.

**Tabelle 1**

| | **Material** | **Dicke (Nanometer)** | **Brechungsindex n** |
|---|---|---|---|
| | Halbleiterkörper | | 2,5 |
| erste Beschichtung | SiN | 62,5 | 1,8 |
| erste Beschichtung | SiO₂ | 75 | 1,5 |
| erste Beschichtung | SiN | 62,5 | 1,8 |
| erste Beschichtung | SiO₂ | 75 | 1,5 |
| erste Beschichtung | SiN | 62,5 | 1,8 |
| erste Beschichtung | SiO₂ | 75 | 1,5 |
| erste Beschichtung | SiN | 62,5 | 1,8 |
| erste Beschichtung | SiO₂ | 75 | 1,5 |
| erste Beschichtung | SiN | 62,5 | 1,8 |
| erste Beschichtung | SiO₂ | 75 | 1,5 |
| erste Beschichtung | SiN | 62,5 | 1,8 |
| erste Beschichtung | SiO₂ | 75 | 1,5 |
| Füllung | SiN | x | 1,8 |
| zweite Beschichtung | SiO₂ | 75 | 1,5 |
| zweite Beschichtung | SiN | 62,5 | 1,8 |
| zweite Beschichtung | SiO₂ | 75 | 1,5 |
| zweite Beschichtung | SiN | 62,5 | 1,8 |
| zweite Beschichtung | SiO₂ | 75 | 1,5 |
| zweite Beschichtung | SiN | 62,5 | 1,8 |
| zweite Beschichtung | SiO₂ | 75 | 1,5 |
| zweite Beschichtung | SiN | 62,5 | 1,8 |
| zweite Beschichtung | SiO₂ | 75 | 1,5 |
| zweite Beschichtung | SiN | 62,5 | 1,8 |
| zweite Beschichtung | SiO₂ | 75 | 1,5 |
| zweite Beschichtung | SiN | 62,5 | 1,8 |
| | Halbleiterkörper | | 2,5 |

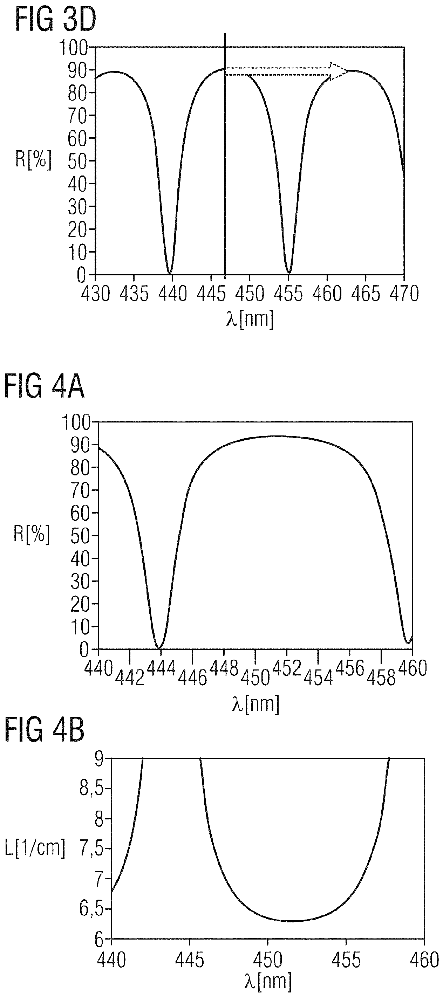

Durch eine Änderung der Ausnehmungsbreite ändert sich bei gleichbleibender Beschichtung die in der Tabelle angegebene Breite x der Füllung, wodurch sich die Modulationen verschieben. In Figur 3A ist für eine Wellenlänge im Bereich von 450 nm die Reflektivität R der gefüllten Ausnehmung in Abhängigkeit von der Wellenlänge λ für x = 3040 nm gezeigt, was beispielsweise für eine angedeutete Wellenlänge von etwa 446 nm eine Reflektivitätsmaximum bedeutet. Für x = 3070 nm (Figur 3B) und x = 3100 nm (Figur 3C) verschiebt sich das Maximum zu höheren Wellenlängen hin, wie durch den jeweiligen Pfeil angedeutet ist. Die Verschiebung ist periodisch, im gezeigten Beispiel liegt daher für x = 3165 nm wieder ein Maximum bei der gleichen Position wie bei x = 3040 nm, wie in Figur 3D gezeigt ist. Aufgrund dieser Periodizität ist die absolute Ausnehmungsbreite unkritisch, da die relativen Änderungen der Ausnehmungsbreite die Verschiebung hervorrufen.

In den Figuren 4A und 4B sind Simulationen der Reflektivität R und der Spiegelverluste L in Abhängigkeit von der Wellenlänge λ für eine Beschichtung gemäß einem weiteren Ausführungsbeispiel gezeigt. Die Spiegelverluste L berechnen sich nach der Formel L = -ln((R1×R2)/(2×L)), wobei R1 die Reflektivität der Ausnehmung gemäß Figur 4A, R2 die Reflektivität des durch die zweite Schicht gebildeten Spiegels auf der Auskoppelseite und L die Resonatorlänge angeben. Für die Simulation in Figur 4B wurden die Werte R2 = 50% und L = 600 µm angenommen.

Wie in Figur 4B leicht zu erkennen ist, haben bereits geringe Änderungen der Reflektivität der Ausnehmung deutliche Änderungen der Spiegelverluste L zur Folge, sodass das im aktiven Bereich erzeugte Licht auf die Wellenlänge mit den geringsten Spiegelverlusten gezwungen wird, da ein Laser üblicherweise bei der Wellenlänge mit den geringsten Verlusten zu lasen beginnt. Daher verschiebt sich die Wellenlänge des im aktiven Bereich einer Emittereinheit erzeugten Lichts mit der in den Figuren 3A bis 3D gezeigten Verschiebung des Reflexionsspektrums durch Änderung der Ausnehmungsbreite. Dieses Prinzip ist unabhängig davon, ob die Ausnehmungen im Bereich der Rückseite oder im Bereich der Auskoppelseite angeordnet sind.

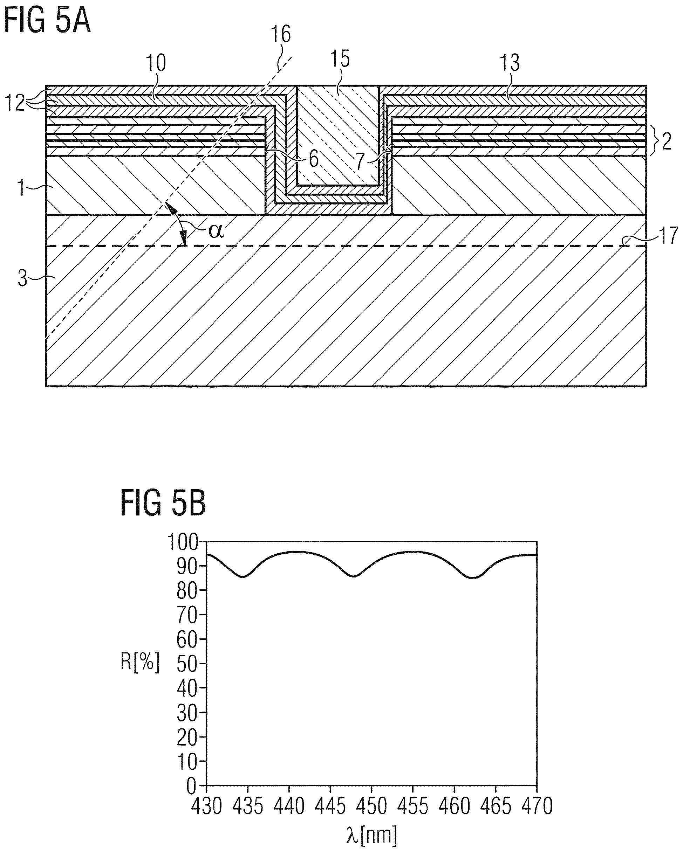

Durch geeignete Beschichtungen lassen sich verschiedene Reflektivitäten, Modulationstiefen und Periodizitäten einstellen. Die Figuren 5A und 5B zeigen gemäß einem weiteren Ausführungsbeispiel eine schematische Darstellung eines Teils einer Emittereinheit eines Licht emittierenden Halbleiterchips mit unterschiedlicher erster und zweiter Beschichtung 10, 13 und einer Füllung 15 sowie eine Simulation der Reflektivität R in Abhängigkeit von der Wellenlänge λ für eine derartige Beschichtung. Rein beispielhaft und der Übersichtlichkeit halber sind in der Figur 5A nur jeweils drei Einzelschichten 12 für die erste und zweite Beschichtung gezeigt.

Im Vergleich zu den vorherigen Ausführungsbeispielen ist die zweite Beschichtung 13 auf der zweiten Seitenfläche 7 halb so dick wie die erste Beschichtung 10 auf der ersten Seitenfläche 6. Hierzu können beispielsweise die erste Beschichtung 10 und die zweite Beschichtung 13 getrennt voneinander und damit nacheinander abgeschieden werden. Dazu können geeignete Verfahrensschritte wie im allgemeinen Teil beschrieben eingesetzt werden. Weiterhin können die erste Beschichtung 10 und die zweite Beschichtung 13 auch zeitgleich abgeschieden werden. Hierzu wird beispielsweise ein Abscheideverfahren verwendet, das eine Vorzugsrichtung 16 aufweist, die einen Winkel α mit einer Haupterstreckungsebene 17 des Halbleiterkörpers 1 aufweist. So erfolgt eine gleichzeitige Abscheidung der ersten Beschichtung 10 und der zweiten Beschichtung 13, wobei die zweite Beschichtung 13 zumindest auf der zweiten Seitenfläche 7 eine andere Dicke aufweist als die erste Beschichtung 10 auf der ersten Seitenfläche 6. Dies wird durch eine Selbstabschattung der Ausnehmung 4 bei der Abscheidung aufgrund der Vorzugsrichtung 16 erzielt. Beispielsweise eignen sich Sputtern oder Aufdampfen als gerichtete Abscheideverfahren. Durch eine geeignete Wahl des Winkels α kann das Dickenverhältnis zwischen der ersten und zweiten Beschichtung 10, 13 auf den Seitenflächen 6, 7 eingestellt werden.

Die so hergestellte erste und zweite Beschichtung 10, 13 weisen jeweils eine Schichtenfolge von Einzelschichten 12 gleichen Materials und gleicher Abfolge auf. Die erste Beschichtung 10 und die zweite Beschichtung 13 unterscheiden sich lediglich durch ihre Dicke auf der ersten Seitenfläche 6 und der zweiten Seitenfläche 7 der Ausnehmung 4. Der verbleibende Spalt wird wie im Ausführungsbeispiel der Figur 2B mit einer Füllung 15 gefüllt.

In Figur 5B ist eine Simulation der Reflektivität R in Abhängigkeit von der Wellenlänge λ für eine derartige Beschichtung mit der ersten und zweiten Beschichtung 10, 13 und der Füllung 15 mit der in der Tabelle 2 angegebenen Zusammensetzung dargestellt.

**Tabelle 2**

| | **Material** | **Dicke (Nanometer)** | **Brechungsindex n** |
|---|---|---|---|
| | Halbleiterkörper | | 2,5 |
| erste Beschichtung | SiO₂ | 73 | 1,5 |
| erste Beschichtung | TiO | 47 | 2,2 |
| erste Beschichtung | SiO₂ | 79 | 1,5 |
| erste Beschichtung | TiO | 50 | 2,2 |
| erste Beschichtung | SiO₂ | 75 | 1,5 |
| erste Beschichtung | TiO | 49 | 2,2 |
| erste Beschichtung | SiO₂ | 72 | 1,5 |
| erste Beschichtung | TiO | 52 | 2,2 |
| erste Beschichtung | SiO₂ | 78 | 1,5 |
| erste Beschichtung | TiO | 44 | 2,2 |
| Füllung | TiO | 3000 | 2,2 |
| zweite Beschichtung | TiO | 22 | 2,2 |
| zweite Beschichtung | SiO₂ | 39 | 1,5 |
| zweite Beschichtung | TiO | 26 | 2,2 |
| zweite Beschichtung | SiO₂ | 36 | 1,5 |
| zweite Beschichtung | TiO | 24,5 | 2,2 |
| zweite Beschichtung | SiO₂ | 37,5 | 1,5 |
| zweite Beschichtung | TiO | 25 | 2,2 |
| zweite Beschichtung | SiO₂ | 39, 5 | 1,5 |
| zweite Beschichtung | TiO | 23,5 | 2,2 |
| zweite Beschichtung | SiO₂ | 36, 5 | 1,5 |
| | Halbleiterkörper | | 2,5 |

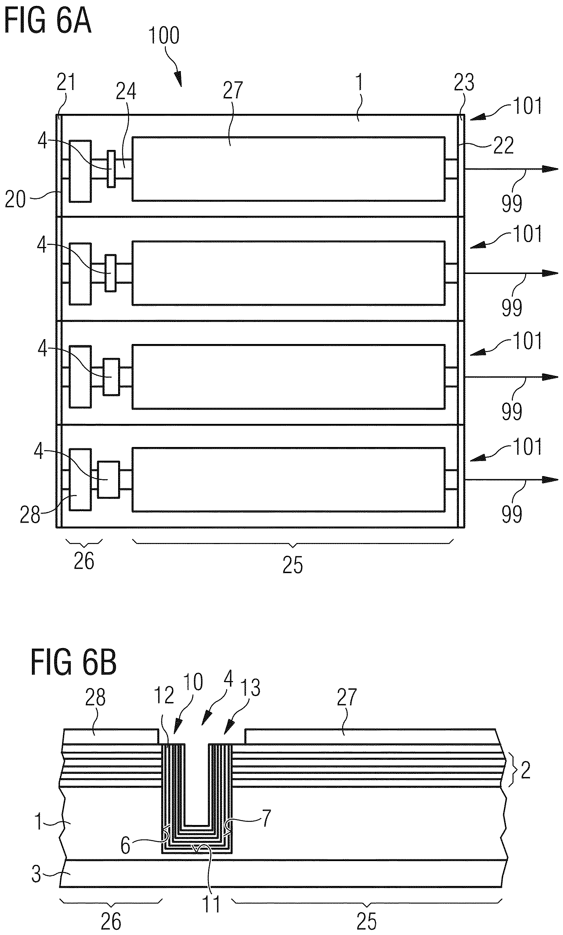

In den Figuren 6A und 6B sind schematische Darstellungen eines Licht emittierenden Halbleiterchips 100 gemäß einem weiteren Ausführungsbeispiel gezeigt, bei dem zusätzlich zum ersten Segment 25 auch das zweite Segment 26 jeder Emittereinheit 101 im Vergleich zu vorherigen Ausführungsbeispielen mittels zweiten elektrischen Kontaktstellen 28, beispielsweise Elektrodenschichten, elektrisch kontaktiert ist. Beispielsweise können die zweiten Segmente 26 der Emittereinheiten 101 als integrierte Fotodiode ausgebildet und genutzt werden. Dafür kann es vorteilhaft sein, wenn die Reflektivität der Ausnehmungen 4 durch eine geeignete Beschichtung beispielsweise auf kleiner oder gleich 99%, bevorzugt kleiner oder gleich 97% und besonders bevorzugt kleiner oder gleich 95% eingestellt wird. Die erste Schicht 21 auf der Rückseite 20 ist besonders bevorzugt eine Entspiegelung, um Rückreflexionen in Richtung der ersten Segmente 25 zu vermeiden.

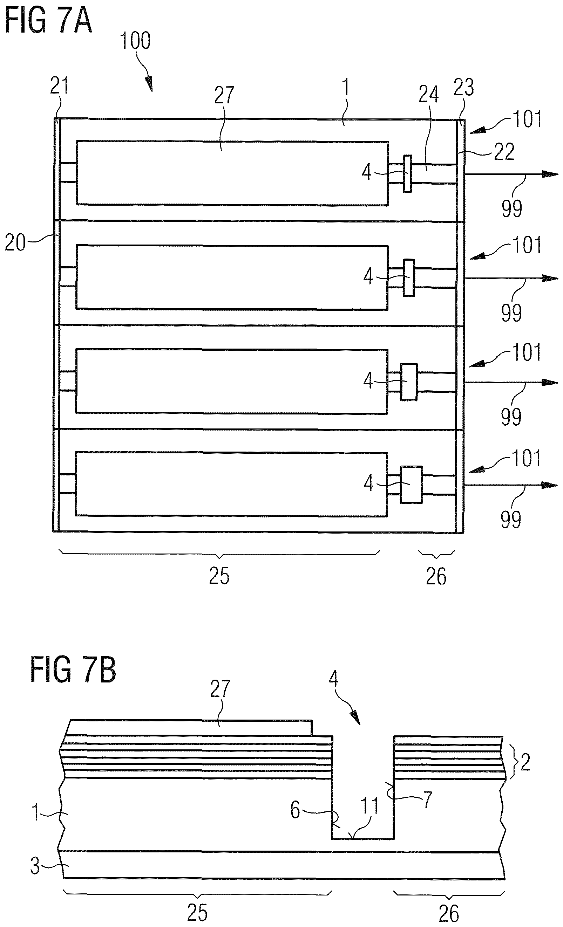

Die Figuren 7A und 7B zeigen schematische Darstellungen eines Licht emittierenden Halbleiterchips 100 gemäß einem weiteren Ausführungsbeispiel, bei dem im Vergleich zu den vorherigen Ausführungsbeispielen die Ausnehmungen 4 mit unterschiedlicher Ausnehmungsbreite im Bereich der Auskoppelseite 22 angeordnet sind.

Die Ausnehmungen 4 sind wie gezeigt ungefüllt oder können alternativ beispielsweise mit einem Material mit einem bestimmten Brechungsindex gefüllt sein. Die zweite Schicht 23 auf der Auskoppelseite 22 wird durch eine Beschichtung mit sehr niedriger Reflektivität gebildet, die Rückreflexionen in den Halbleiterkörper 1 vermeidet.

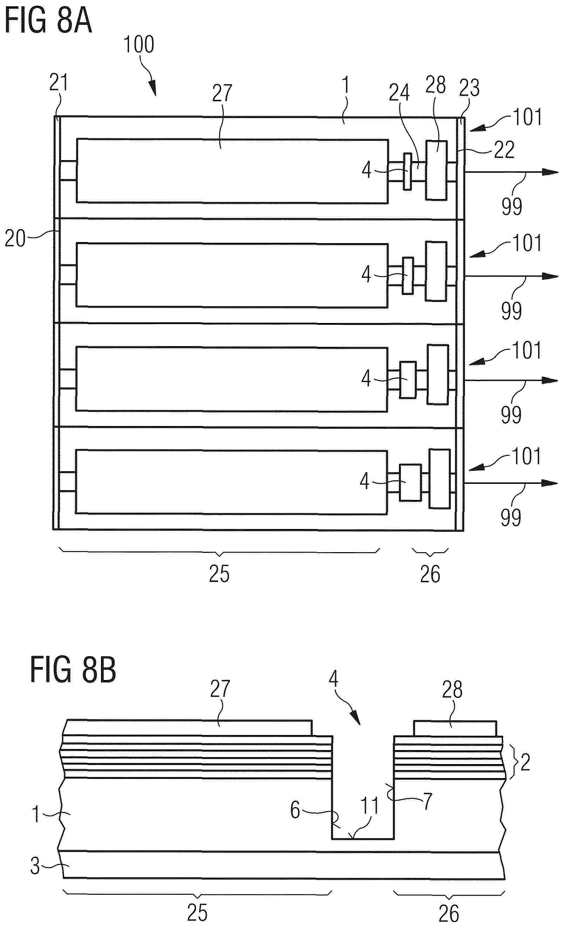

Im hier gezeigten Ausführungsbeispiel sind die zweiten Segmente 26 an der Auskoppelseite 22 nicht elektrisch kontaktiert und damit passiv ausgebildet. Alternativ hierzu, wie in den Figuren 8A und 8B gezeigt ist, können jedoch diese auch separat mittels zweiter elektrischer Kontaktstellen 28 elektrisch kontaktiert werden.

Die zweiten Segmente 26 haben durch die nicht-reflektierende zweite Schicht 23 keinen Einfluss auf die Reflektivität an der Auskoppelseite 22. Die Reflektivität wird vielmehr über die Ausnehmungen 4 definiert. Durch das effektive "Verlegen" der Position der Auskoppel-Reflektivität von der Facette des Halbleiterkörpers 1 an der Auskoppelseite 22 des Licht emittierenden Halbleiterchips 100 in die Ausnehmungen 4 kann mit Vorteil erreicht werden, dass die zweiten Segmente 26 mit zusätzlichen Eigenschaften genutzt werden können. Diese können beispielsweise, gegebenenfalls in Kombination mit Änderungen der Stegwellenleitergeometrie in den zweiten Segmenten 26, als Modenfilter oder für eine spektrale Aufweitung oder als Modulator etc. verwendet werden.

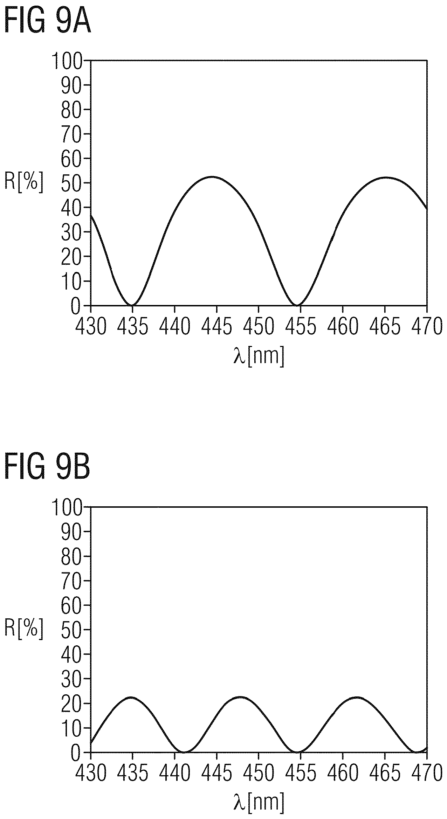

Im einfachsten Fall lässt sich die Modulation über eine ungefüllte oder eine mit einem Material gefüllte Ausnehmung 4 in den aktiven Bereichen 2 der Emittereinheiten 101 realisieren. Damit sind beispielsweise Reflektivitäten von kleiner als etwa 50% im AlInGaN-Materialsystem mit luftgefüllten Ausnehmungen 4 möglich, wie in Figur 9A in einer weiteren Simulation einer luftgefüllten Ausnehmung mit einer Ausnehmungsbreite von 5000 nm gezeigt ist. Durch Füllung mit einem Material mit höherem Brechungsindex kann eine geringere Reflektivität eingestellt werden, wie in Figur 9B in einer weiteren Simulation mit einer ebensolchen Ausnehmung gezeigt ist, die mit SiO₂ mit einem Brechungsindex von 1,5 gefüllt ist. Da die Modulationen im Falle von Luftfüllungen einen relativ großen Abstand aufweisen, ist gegebenenfalls eine große Ausnehmungsbreite nötig, um den nötigen geringeren Modulationsabstand zu erhalten. Da dies jedoch eine Verringerung der Koppeleffizienz mit sich bringt und für manche Anwendungen Reflektivitäten benötigt werden, die größer als 50% sind oder die sich mit einem einzelnen Füllmaterial nicht einstellen lassen, können alternativ Mehrschicht-Beschichtungen verwendet werden, wie sie beispielsweise im Folgenden beschrieben sind.

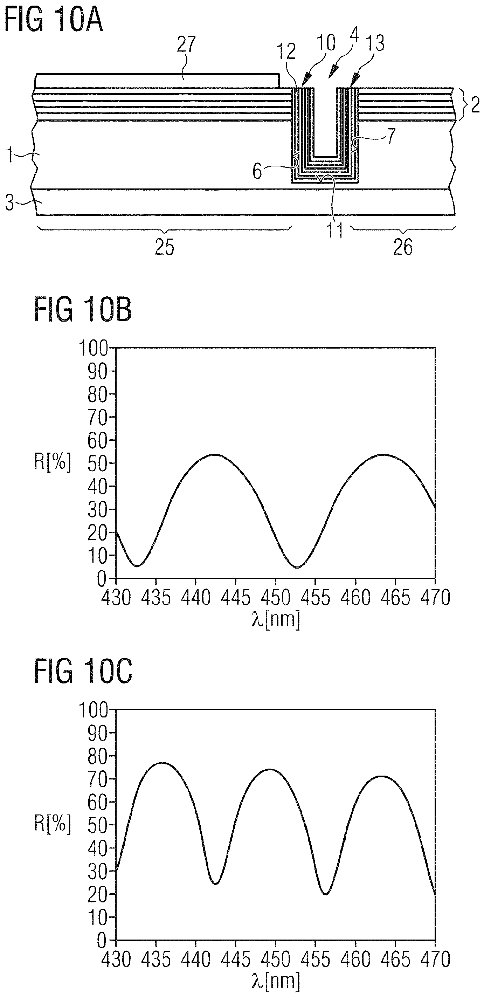

In Figur 10A ist in einer schematischen Teildarstellung eine Emittereinheit eines Licht emittierenden Halbleiterchips gemäß dem Ausführungsbeispiel der Figuren 7A und 7B gezeigt, wobei anders als im Ausführungsbeispiel der Figuren 7A und 7B zusätzlich eine solche Beschichtung in Form einer ersten Beschichtung 10 und einer zweiten Beschichtung 13 in den Ausnehmungen 4 aufgebracht wird. Die Figuren 10B und 10C zeigen Simulationen der Reflektivität R in Abhängigkeit von der Wellenlänge λ für Beschichtungen gemäß den Tabellen 3 und 4.

**Tabelle 3**

| | **Material** | **Dicke (Nanometer)** | **Brechungsindex n** |
|---|---|---|---|
| | Halbleiterkörper | | 2,5 |
| erste Beschichtung | TiO | 34 | 2,2 |
| erste Beschichtung | SiO₂ | 148 | 1,5 |
| erste Beschichtung | TiO | 33 | 2,2 |
| erste Beschichtung | SiO₂ | 94 | 1,5 |
| erste Beschichtung | TiO | 98 | 2,2 |
| Füllung | TiO | 2000 | 2,2 |
| zweite Beschichtung | TiO | 68, 6 | 2,2 |
| zweite Beschichtung | SiO₂ | 65, 8 | 1,5 |
| zweite Beschichtung | TiO | 23, 1 | 2,2 |
| zweite Beschichtung | SiO₂ | 103,6 | 1,5 |
| zweite Beschichtung | TiO | 23,8 | 2,2 |
| | Halbleiterkörper | | 2,5 |

**Tabelle 4**

| | **Material** | **Dicke (Nanometer)** | **Brechungsindex n** |
|---|---|---|---|
| | Halbleiterkörper | | 2,5 |
| erste Beschichtung | SiO₂ | 24 | 1,5 |
| erste Beschichtung | TiO | 79 | 2,2 |
| erste Beschichtung | SiO₂ | 70 | 1,5 |
| erste Beschichtung | TiO | 54 | 2,2 |
| erste Beschichtung | SiO₂ | 39 | 1,5 |
| erste Beschichtung | TiO | 74 | 2,2 |
| erste Beschichtung | SiO₂ | 157 | 1,5 |
| Füllung | TiO | 3050 | 2,2 |
| zweite Beschichtung | SiO₂ | 78,5 | 1,5 |
| zweite Beschichtung | TiO | 37 | 2,2 |
| zweite Beschichtung | SiO₂ | 19, 5 | 1,5 |
| zweite Beschichtung | TiO | 27 | 2,2 |
| zweite Beschichtung | SiO₂ | 35 | 1,5 |
| zweite Beschichtung | TiO | 39, 5 | 2,2 |
| zweite Beschichtung | SiO₂ | 12 | 1,5 |
| | Halbleiterkörper | | 2,5 |

Wie in Figur 10B zu erkennen ist, kann mit der in Tabelle 3 angegebenen Beschichtung, bei der die Dicke der zweiten Beschichtung im Bereich der zweiten Seitenfläche zu einer Dicke der ersten Beschichtung im Bereich der ersten Seitenfläche ein Verhältnis von 7:10 aufweist, eine ähnliche Modulationshöhe und Modulationsbreite wie bei der in Verbindung den Figuren 7A, 7B und 9A gezeigten luftgefüllten Ausnehmung erreicht werden, allerdings mit einer deutlich kleineren Ausnehmungsbreite. Dadurch ergeben sich geringere Koppelverluste und damit eine bessere Laserperformance.

Wie in Figur 10C zu erkennen ist, kann mit der in Tabelle 4 angegebenen Beschichtung, bei der die Dicke der zweiten Beschichtung im Bereich der zweiten Seitenfläche zur Dicke der ersten Beschichtung im Bereich der ersten Seitenfläche ein Verhältnis von 1:2 aufweist, eine Reflektivität von etwa 75% erreicht werden, was mit rein luftgefüllten Ausnehmungen nicht möglich wäre. Anhand der in Verbindung mit den in den Figuren 10B und 10C erläuterten Beschichtungen kann gesehen werden, dass mit einer Beschichtung in den Ausnehmungen eine beliebige Reflektivität eingestellt werden kann.

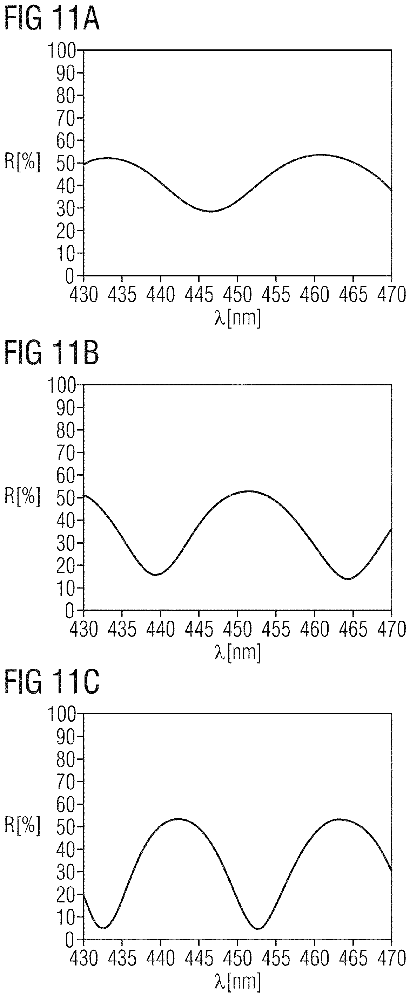

Der Modulationsabstand, also der Abstand zwischen Reflexionsmaxima, lässt sich beispielsweise über den Brechungsindex der Füllung einstellen. Je höher der Brechungsindex n der Füllung ist, desto geringer ist der Modulationsabstand, da dieser proportional zu λ²/(2×n×B) ist, wobei B die Breite der Füllung angibt. Die Figuren 11A bis 11C zeigen diesen Zusammenhang in Simulationen der Reflektivität R in Abhängigkeit von der Wellenlänge λ für Beschichtungen gemäß weiteren Ausführungsbeispielen mit der in Tabelle 5 angegebenen Zusammensetzung. Der Brechungsindex der Füllung ist n = 1,5 (Figur 11A), n = 1,8 (Figur 11B) und n = 2,2 (Figur 11C). Aufgrund der Variation des Brechungsindex n der Füllung ist für diese in der Tabelle 5 kein beispielhaftes Material angegeben. Entsprechend der gewünschten Reflektivität kann dieses von einem Fachmann gezielt ausgewählt werden. Beispielsweise kann für den Brechungsindex n = 2,2 TiO gewählt werden. In diesem Fall entsprechen die Zusammensetzung der Beschichtung und damit die in Figur 11C gezeigte Reflektivität der Zusammensetzung der Beschichtung und der Reflektivität, die in Verbindung mit der Figur 10B erläutert sind. Für die Brechungsindices n = 1,5 und n = 1,8 können beispielsweise SiO₂ und SiN gewählt werden.

**Tabelle 5**

| | **Material** | **Dicke (Nanometer)** | **Brechungsindex n** |
|---|---|---|---|
| | Halbleiterkörper | | 2,5 |
| erste Beschichtung | TiO | 34 | 2,2 |
| erste Beschichtung | SiO₂ | 148 | 1,5 |
| erste Beschichtung | TiO | 33 | 2,2 |
| erste Beschichtung | SiO₂ | 94 | 1,5 |
| erste Beschichtung | TiO | 98 | 2,2 |
| Füllung | | 2000 | n |
| zweite Beschichtung | TiO | 68,6 | 2,2 |
| zweite Beschichtung | SiO₂ | 65,8 | 1,5 |
| zweite Beschichtung | TiO | 23, 1 | 2,2 |
| zweite Beschichtung | SiO₂ | 103,6 | 1,5 |
| zweite Beschichtung | TiO | 23,8 | 2,2 |
| | Halbleiterkörper | | 2,5 |

Aus der Abhängigkeit λ²/(2×n×B) des Modulationsabstands ist auch erkennbar, dass mit größer werdender Breite der Füllung der Abstand der Reflexionsmaxima geringer wird. Die Position der Maxima wiederholt sich proportional zu λ/(2×n), die Verschiebung der Maxima mit der Breite B der Füllung ist proportional zu λ/B. Je größer die Breite der Füllung und damit auch die Ausnehmungsbreite bei einer fest gewählten ersten und zweiten Beschichtung sind, desto geringer ist somit die Verschiebung der Maxima mit Änderung der Schlitzbreite.

In Tabelle 6 ist der in Tabelle 3 wiedergegebene Aufbau der Beschichtung gezeigt, wobei im Vergleich zur Tabelle 3 die Breite B der Füllung variabel angegeben ist.

**Tabelle 6**

| | **Material** | **Dicke (Nanometer)** | **Brechungsindex n** |
|---|---|---|---|
| | Halbleiterkörper | | 2,5 |
| erste Beschichtung | TiO | 34 | 2,2 |
| erste Beschichtung | SiO₂ | 148 | 1,5 |
| erste Beschichtung | TiO | 33 | 2,2 |
| erste Beschichtung | SiO₂ | 94 | 1,5 |
| erste Beschichtung | TiO | 98 | 2,2 |
| Füllung | TiO | B | 2,2 |
| zweite Beschichtung | TiO | 68,6 | 2,2 |
| zweite Beschichtung | SiO₂ | 65,8 | 1,5 |
| zweite Beschichtung | TiO | 23,1 | 2,2 |
| zweite Beschichtung | SiO₂ | 103,6 | 1,5 |
| zweite Beschichtung | TiO | 23,8 | 2,2 |
| | Halbleiterkörper | | 2,5 |

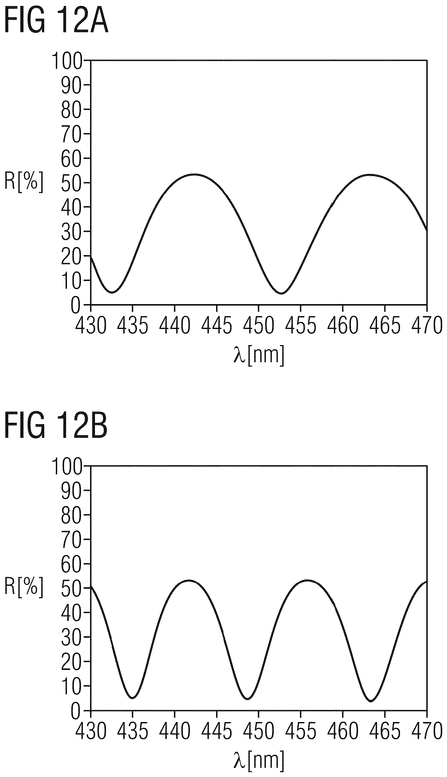

Die Figuren 12A und 12B zeigen Simulationen der Reflektivität R in Abhängigkeit von der Wellenlänge λ für die in Tabelle 6 angegebene Zusammensetzung mit B = 2000 nm und B = 3000 nm. Die in Figur 12A gezeigte Reflektivität entspricht somit der in Figur 10B gezeigten.

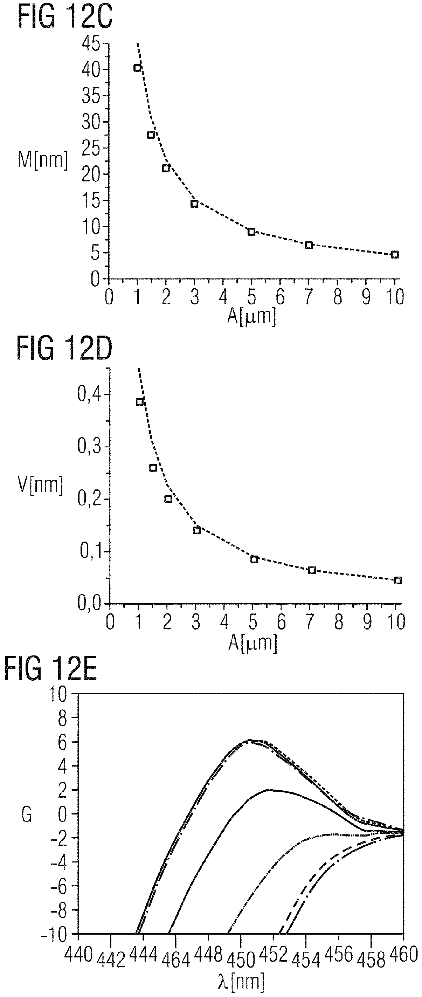

Die Figuren 12C und 12D zeigen Simulationen für den Abstand M der Maxima, also den Modulationsabstand, sowie für die Verschiebung V der Maxima in Abhängigkeit von der Ausnehmungsbreite A, während in Figur 12E eine beispielhafte Simulation des Gains G einer Laserdiode in Abhängigkeit von der Wellenlänge λ für verschiedene Betriebsströme gezeigt ist. Bei einer fest gewählten ersten und zweiten Beschichtung gelten die vorgenannten Abhängigkeiten von der Füllungsbreite B entsprechend auch in Bezug auf die Ausnehmungsbreite A. Um die Emittereinheiten auf unterschiedliche Wellenlängen zu zwingen, sollte der Abstand M zwischen den Maxima größer als die (Halbwerts-)Breite des Gainspektrums sein, woraus folgt, dass eine kleinere Ausnehmungsbreite hierfür vorteilhaft ist. Gleichzeitig sollte die Verschiebung V der Maxima möglichst gering sein, damit die Unterschiede zwischen den Emittereinheiten möglichst gut eingestellt werden können und Prozessschwankungen nur geringe Auswirkung haben, woraus folgt, dass große Ausnehmungsbreiten A vorteilhaft sind. Um Koppelverluste gering zu halten, sollte die Ausnehmungsbreite A wiederum möglichst klein sein. Aus diesen Randbedingungen folgt für bevorzugte Ausführungsbeispiele, dass die Ausnehmungsbreite größer oder gleich 0,1 nm und kleiner oder gleich 20 µm, bevorzugt größer oder gleich 0,3 nm und kleiner oder gleich 10 µm und besonders bevorzugt größer oder gleich 0,5 nm und kleiner oder gleich 5 µm ist.

Die vorab beschriebenen Merkmale und Ausführungsbeispiele für die Ausnehmungen und die Beschichtung der Ausnehmungen sind rein beispielhaft zu verstehen. Insbesondere können je nach Wellenlängenspektrum und technischen Anforderungen des Licht emittierenden Halbleiterchips Materialien, Schichtdicken, Schichtkombinationen, Füllungen, Ausnehmungsbreiten und Ausnehmungspositionen gezielt angepasst werden.

In Verbindung mit den nachfolgenden Figuren sind weitere Ausführungsbeispiele für den Aufbau des Licht emittierenden Halbleiterchips und insbesondere der Emittereinheiten gezeigt, die Modifikationen der vorab beschriebenen Ausführungsbeispiele darstellen.

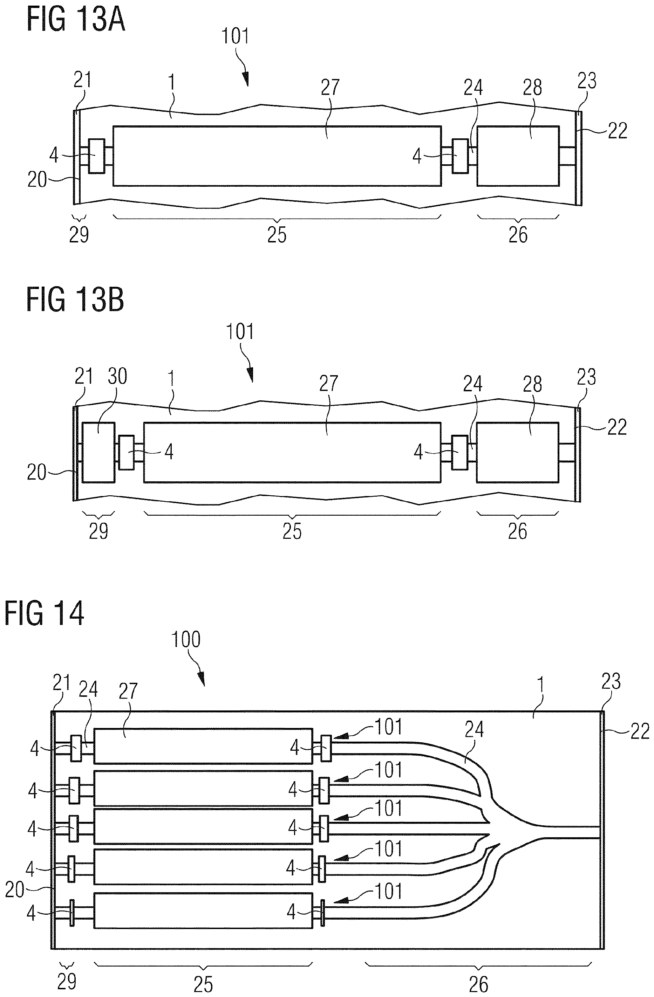

Die Figuren 13A und 13B zeigen Emittereinheiten 101 für einen Licht emittierende Halbleiterchip, die zwei Ausnehmungen 4 aufweisen, von denen eine im Bereich der Rückseite 20 und die andere im Bereich der Auskoppelseite 22 ausgebildet sind. Dadurch weisen die gezeigte Emittereinheiten 101 jeweils ein erstes Segment 25, das den Licht erzeugenden Teil bildet, ein zweites Segment 26 im Bereich der Auskoppelseite 22, das beispielsweise wie in Verbindung mit den Figuren 8A und 8B beschrieben ausgebildet sein kann, und ein drittes Segment 29 im Bereich der Rückseite 29 auf. Für die in Figur 13A gezeigte Emittereinheit 101 kann das rückseitige dritte Segment 29 wie in Verbindung mit den Figuren 1A bis 2B beschrieben als unkontaktiertes und somit passives Segment ausgebildet sein, während das rückseitige dritte Segment 29 für die in Figur 13B gezeigte Emittereinheit 101 wie in Verbindung mit den Figuren 6A und 6B beschrieben als aktives Segment ausgebildet sein kann, das eine dritte elektrische Kontaktstelle 30, beispielsweise eine Elektrodenschicht, aufweist. Insbesondere können beispielsweise die Ausnehmung 4 im Bereich der Rückseite 20 eine Rückseitenverspiegelung und die Ausnehmung 4 im Bereich der Auskoppelseite 22 eine Auskoppelverspiegelung für den durch das erste Segment 25 gebildeten Resonator bilden. Die erste und zweite Schicht 21, 23 können möglichst gering reflektierend ausgebildet sein. Die Ausnehmungen 4 im Bereich der Rückseite 20 sowie die Ausnehmungen 4 im Bereich der Auskoppelseite 22 können wie in den vorab beschriebenen Ausführungsbeispielen ausgebildet sein und insbesondere jeweils unterschiedliche Ausnehmungsbreiten aufweisen, wie auch in den Figuren in Verbindung mit den nachfolgenden Ausführungsbeispielen erkennbar ist. Die Ausnehmungen 4, die einer selben Emittereinheit 101 zugeordnet sind, können in Bezug auf die Dimensionen und/oder eine Beschichtung gleich oder verschieden ausgebildet sein.

Durch eine Kombination von mehreren Ausnehmungen 4 pro Emittereinheit 101 wie der in den Figuren 13A und 13B gezeigten können Modulationseffekte verstärkt und/oder schmalere Reflexionsmaxima erreicht werden. Beispielsweise lassen sich auch durch unterschiedliche Ausbildungen der Ausnehmungen in Bezug auf die Ausnehmungsbreite und die Beschichtung Überlagerungseffekte erzielen. Da die Maxima der jeweiligen Reflexionsspektren eine gewisse spektrale Breite haben, lässt sich durch zwei leicht gegeneinander verschobene Spektren im Bereich der Auskoppelseite und im Bereich der Rückseite ein deutlich schmaleres Wellenlängenfenster erzielen, in dem die Emittereinheit 101 emittieren muss. Sind die Ausbildungen der Ausnehmungen im Bereich der Auskoppelseite und im Bereich der Rückseite unterschiedlich, können beispielsweise mehrfach gewellte Spektren erzeugt werden. Sind die Ausbildungen der Ausnehmungen im Bereich der Auskoppelseite und im Bereich der Rückseite hingegen gleich, kann eine Verstärkung der Modulation erreicht werden. Alternativ zu den gezeigten Ausführungsbeispielen können auch andere Kombinationen mit ein, zwei oder mehr aktiven und/oder passiven Segmenten durch eine geeignete Anzahl und Anordnung von Ausnehmungen möglich sein.

Das in Figur 14 gezeigte Ausführungsbeispiel für den Licht emittierenden Halbleiterchip 100 weist wiederum pro Emittereinheit 101 rein beispielhaft zwei Ausnehmungen 4 zur Unterteilung in drei Segmente 25, 26, 29 auf, wobei die Stegwellenleiterstruktur 24 im zweiten Bereich 26 als Wellenleiter und Kombinierer ausgebildet ist. Der Licht emittierende Halbleiterchip 100 kann somit als photonisch integriertes Laserbauteil ausgebildet sein. Alternativ zu den passiv ausgebildeten dritten Segmenten 29 können diese hier und auch in den folgenden Ausführungsbeispielen beispielsweise auch als integrierte Fotodiode und damit aktiv ausgebildet sein, wie weiter oben beschrieben ist.

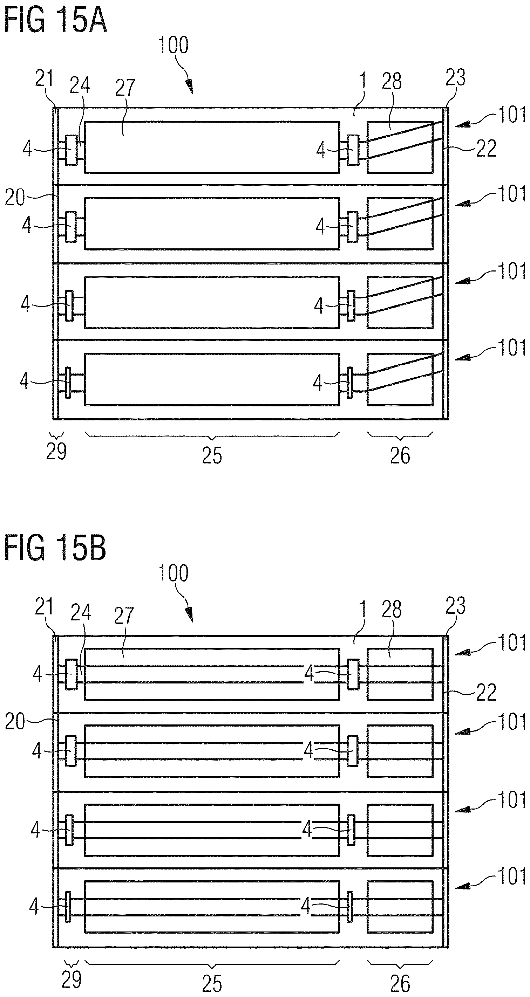

In den in den Figuren 15A und 15B gezeigten Ausführungsbeispielen für den Licht emittierenden Halbleiterchip 100 weisen die Stegwellenleiterstrukturen 24 der Emittereinheiten 101 im zweiten Segment 26 jeweils eine Schräge (Figur 15A) oder eine Krümmung (Figur 15B) auf, was zu einem superlumineszenten Verhalten führen kann. Die Licht emittierenden Halbleiterchips 100 gemäß den Figuren 15A und 15B können somit als Superlumineszenzdioden ausgebildet sein.

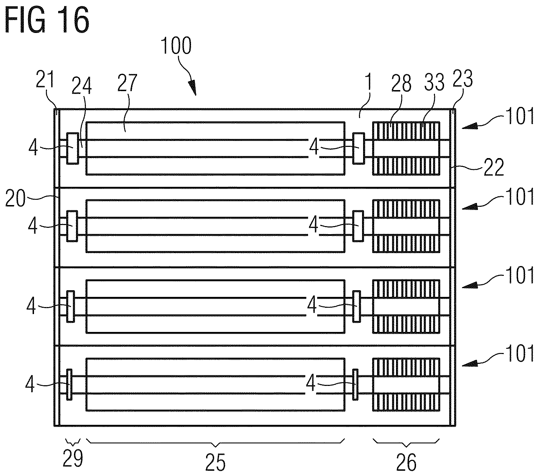

In Figur 16 ist ein weiteres Ausführungsbeispiel für den Licht emittierenden Halbleiterchip 100 gezeigt, bei dem im zweiten Segment 26 der Emittereinheiten 101 jeweils ein wellenlängenselektives Element 33, beispielsweise eine Art Gitter wie beispielsweise eine DFB-Struktur (DFB: "distributed feedback laser", Laser mit verteilter Rückkopplung), vorgesehen ist. Das wellenlängenselektive Element 33 kann beispielsweise seitlich an der Stegwellenleiterstruktur 24 und/oder auf und/oder über und/oder in der Stegwellenleiterstruktur 24 ausgebildet sein.

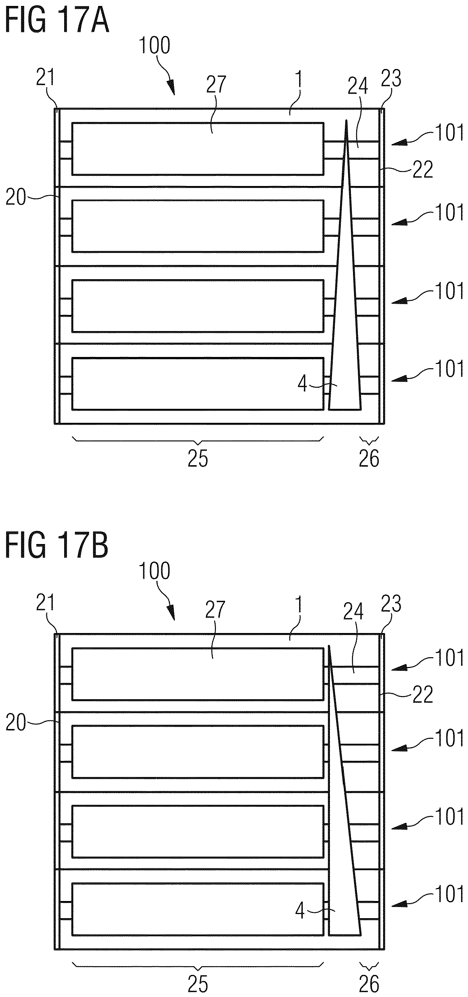

In den vorab beschriebenen Ausführungsbeispielen weist jede Emittereinheit 101 des Licht emittierenden Halbleiterchips 100 zumindest eine eigens zugeordnete Ausnehmung 4 auf, die jeweils getrennt von allen anderen Ausnehmungen 4 im Halbleiterkörper 1 ist. Alternativ hierzu kann im Halbleiterkörper 1 auch zumindest eine Ausnehmung 4 vorhanden sein, die sich durch die aktiven Bereiche mehrerer und bevorzugt aller Emittereinheiten 101 erstreckt, wie in den Figuren 17A und 17B gezeigt ist. Die Ausnehmung 4 kann somit als durchgehender Schlitz oder Spalt mit sich ändernder Ausnehmungsbreite ausgeführt sein. Dabei kann vorteilhaft zumindest eine Seitenfläche der Ausnehmung senkrecht zur Abstrahlrichtung des erzeugten Lichts ausgerichtet sein. In den gezeigten Ausführungsbeispielen sind alle aktiven Bereiche des Licht emittierenden Halbleiterchips 100 jeweils durch eine einzige Ausnehmung 4 durchdrungen. Damit sich die Ausnehmungsbreiten für die Emittereinheiten 101 unterscheiden, kann die Ausnehmung 4 eine Grundfläche mit einer doppelseitigen oder einseitigen Keilform aufweisen, wie in den Figuren 17A und 17B angedeutet ist. Entsprechend können eine oder beide Seitenflächen der Ausnehmung 4 teilweise schräg zur Haupterstreckungsrichtung der Ausnehmung 4 verlaufen. Alternativ oder zusätzlich ist auch ein zumindest teilweise gebogener und/oder gestufter Verlauf einer oder beider Seitenflächen möglich.

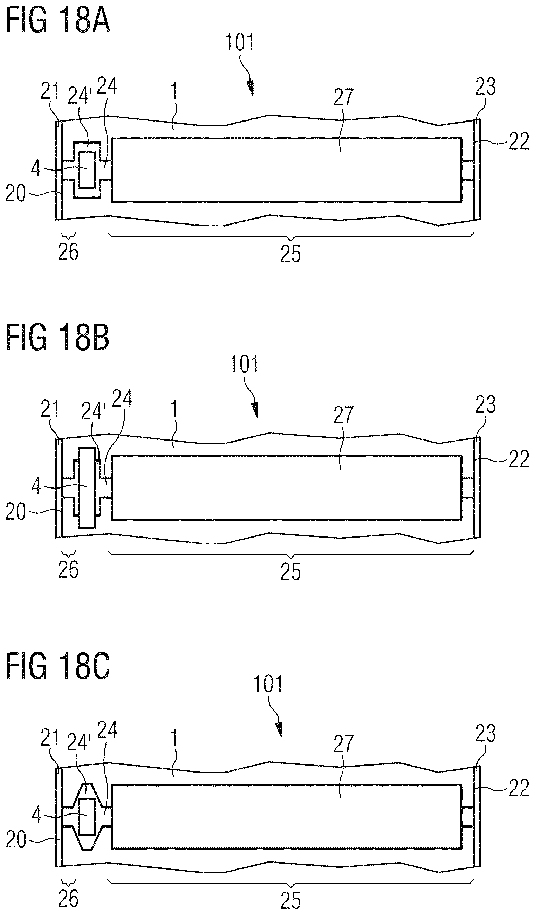

Die Stegwellenleiterstrukturen 24 können, wie in den bisherigen Ausführungsbeispielen gezeigt, beispielsweise als Streifen mit konstanter Breite ausgeführt sein, die von der zumindest einen Ausnehmung 4 unterbrochen werden. Um eine bessere Facettenqualität zu erreichen, können die Stegwellenleiterstrukturen 24 im Bereich der zumindest einen Ausnehmung 4 auch eine Verdickung 24` in Form einer Verbreiterung entlang der Haupterstreckungsrichtung der zumindest einen Ausnehmung 4 aufweisen, wie in den Figuren 18A bis 18C angedeutet ist. Die zumindest eine Ausnehmung 4 kann innerhalb der Verbreiterung 24' liegen (Figur 18A), sie kann gleich breit wie die Verbreiterung 24' sein (nicht gezeigt) oder sie kann über die Verbreiterung 24' entlang der Haupterstreckungsrichtung der Ausnehmung 4 hinausragen (Figur 18B). Die Verdickung 24` kann, wie in den Figuren 18A und 18B angedeutet ist, rechteckig sein. Es kann auch vorteilhaft sein, wenn sich die Stegwellenleiterstruktur 24 allmählich zur Ausnehmung 4 hin aufweitet (Figur 18C), was auch als sogenannter Taper bezeichnet werden kann, um Koppelverluste zu reduzieren.

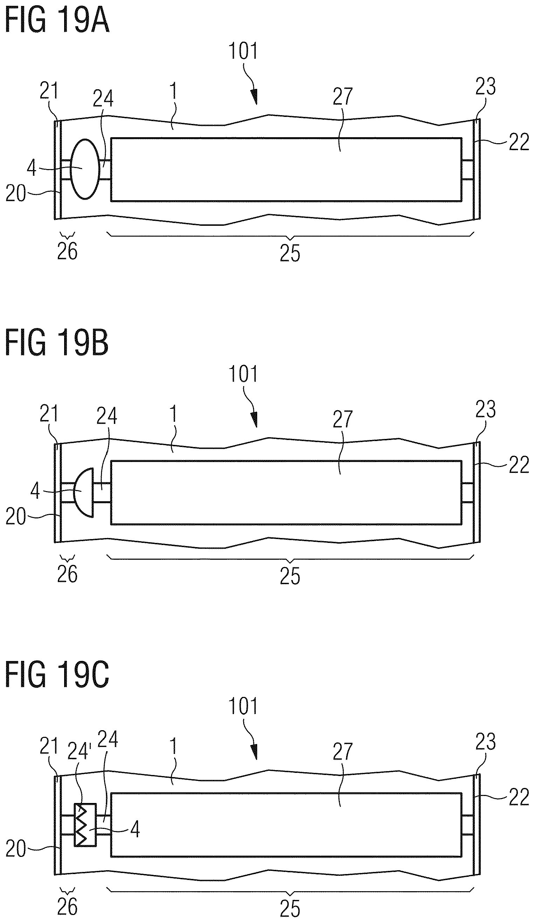

Um Koppelverluste zu verringern, kann die zumindest eine Ausnehmung 4, wie in den Figuren 19A bis 19C angedeutet ist, anstelle einer rechteckigen Grundform auch runde oder einseitig oder beidseitig konvexe oder konkave Formen aufweisen. Rein beispielhaft sind in den Figuren 19A und 19B eine einseitig konvexe und eine beidseitig konvexe Form gezeigt. Die zumindest eine Ausnehmung 4 kann auch komplexere Formen aufweisen, beispielsweise die eines Retroreflektors (Katzenauge), wie in Figur 19C angedeutet ist.

Die in den in Verbindung mit den Figuren beschriebenen Merkmale und Ausführungsbeispiele können gemäß weiteren Ausführungsbeispielen miteinander kombiniert werden, auch wenn nicht alle Kombinationen explizit beschrieben sind. Weiterhin können die in Verbindung mit den Figuren beschriebenen Ausführungsbeispiele alternativ oder zusätzlich weitere Merkmale gemäß der Beschreibung im allgemeinen Teil aufweisen.

Die Erfindung ist nicht durch die Beschreibung anhand der Ausführungsbeispiele auf diese beschränkt. Die Erfindung in den beigefügten Ansprüchen definiert.

### Bezugszeichenliste

- 1: Halbleiterkörper
- 2: aktiver Bereich
- 3: Substrat
- 4: Ausnehmung
- 6: erste Seitenfläche
- 7: zweite Seitenfläche
- 10: erste Beschichtung
- 11: Bodenfläche
- 12: Einzelschicht
- 13: zweite Beschichtung
- 15: Füllung
- 16: Vorzugsrichtung
- 17: Haupterstreckungsebene
- 20: Rückseite des Halbleiterkörpers
- 21: erste Schicht
- 22: Auskoppelseite des Halbleiterkörpers
- 23: zweite Schicht
- 24: Stegwellenleiterstruktur
- 24': Verdickung
- 25: erstes Segment
- 26: zweites Segment
- 27: erste elektrische Kontaktstelle
- 28: zweite elektrische Kontaktstelle
- 29: drittes Segment
- 30: dritte elektrische Kontaktstelle
- 33: wellenlängenselektives Element
- 99: Abstrahlrichtung
- 100: Licht emittierender Halbleiterchip
- 101: Emittereinheit
- A: Ausnehmungsbreite
- E1, E2, E3, E4: Emissionsspektrum

## Patentansprüche

1. Licht emittierender Halbleiterchip (100) aufweisend einen Halbleiterkörper (1) umfassend eine Mehrzahl von Emittereinheiten (101), wobei
jede Emittereinheit einen aktiven Bereich (2) aufweist, der in einem Resonator mit einer Auskoppelseite (22) und einer Rückseite (20) angeordnet ist und der dazu vorgesehen und eingerichtet ist, im Betrieb Licht an der Auskoppelseite entlang einer Abstrahlrichtung (99) zu emittieren,
bei jeder Emittereinheit der aktive Bereich durch zumindest eine Ausnehmung (4) im Halbleiterkörper vollständig durchdrungen ist,
bei jeder Emittereinheit die Ausnehmung im Bereich des aktiven Bereichs eine Ausnehmungsbreite (A), die entlang der Abstrahlrichtung gemessen wird, aufweist, **dadurch gekennzeichnet, dass**
die Ausnehmungsbreiten der Emittereinheiten zumindest teilweise unterschiedlich sind.

2. Licht emittierender Halbleiterchip nach Anspruch 1, wobei sich die Ausnehmungsbreiten der Emittereinheiten um einen Betrag unterscheiden, der größer oder gleich 1 nm und kleiner oder gleich 2 µm ist.

3. Licht emittierender Halbleiterchip nach einem der vorherigen Ansprüche, wobei zumindest drei Emittereinheiten vorhanden sind und sich die Ausnehmungsbreiten der Emittereinheiten äquidistant voneinander unterscheiden.

4. Licht emittierender Halbleiterchip nach einem der vorherigen Ansprüche, wobei jede der Emittereinheiten zumindest eine Ausnehmung aufweist, die von den Ausnehmungen der anderen Emittereinheiten getrennt ist.

5. Licht emittierender Halbleiterchip nach einem der vorherigen Ansprüche, wobei sich die zumindest eine Ausnehmung durch die aktiven Bereiche von zwei oder mehr Emittereinheiten erstreckt.

6. Licht emittierender Halbleiterchip nach dem vorherigen Anspruch, wobei die Ausnehmungsbreite der zumindest einen Ausnehmung von Emittereinheit zu Emittereinheit kontinuierlich oder stufenförmig zunimmt.

7. Licht emittierender Halbleiterchip nach einem der vorherigen Ansprüche, wobei die zumindest eine Ausnehmung eine rechteckige Grundfläche oder eine zumindest teilweise keilförmige und/oder zumindest teilweise abgerundete Grundfläche aufweist.

8. Licht emittierender Halbleiterchip nach einem der vorherigen Ansprüche, wobei für jede Emittereinheit der Halbleiterkörper eine Stegwellenleiterstruktur (24) aufweist und die Stegwellenleiterstruktur im Bereich der zumindest einen Ausnehmung eine Verdickung (24`) in einer Haupterstreckungsrichtung der zumindest einen Ausnehmung aufweist.

9. Licht emittierender Halbleiterchip nach einem der vorherigen Ansprüche, wobei bei jeder Emittereinheit zumindest eine Ausnehmung im Bereich der Rückseite angeordnet ist.

10. Licht emittierender Halbleiterchip nach einem der vorherigen Ansprüche, wobei bei jeder Emittereinheit zumindest eine Ausnehmung im Bereich der Auskoppelseite angeordnet ist.

11. Licht emittierender Halbleiterchip nach einem der vorherigen Ansprüche, wobei bei jeder Emittereinheit der aktive Bereich durch zumindest zwei Ausnehmungen vollständig durchdrungen ist und wobei die eine der Ausnehmungen im Bereich der Rückseite und die andere der Ausnehmungen im Bereich der Auskoppelseite angeordnet ist.

12. Licht emittierender Halbleiterchip nach einem der vorherigen Ansprüche, wobei bei jeder Emittereinheit die zumindest eine Ausnehmung zumindest eine Beschichtung (10, 13, 15) aufweist, die eine Reflektivität der Ausnehmung für das im aktiven Bereich erzeugte Licht vorgibt, wobei die Reflektivität kleiner oder gleich 99,9% und größer oder gleich 80% ist.

13. Licht emittierender Halbleiterchip nach einem der vorherigen Ansprüche, wobei für jede Emittereinheit
- die zumindest eine Ausnehmung in Abstrahlrichtung eine erste Seitenfläche (6) und eine zweite, der ersten Seitenfläche gegenüber liegende Seitenfläche (7) aufweist, und
- die erste Seitenfläche eine erste Beschichtung (10) aufweist, die eine Reflektivität für das im aktiven Bereich erzeugte Licht vorgibt und die als erste Schichtenfolge mit einer Mehrzahl von Einzelschichten (12) ausgebildet ist, und/oder
- die zweite Seitenfläche eine zweite Beschichtung (13) aufweist, die eine Reflektivität für das im aktiven Bereich erzeugte Licht vorgibt und die als zweite Schichtenfolge mit einer Mehrzahl von Einzelschichten (12) ausgebildet ist.

14. Licht emittierender Halbleiterchip nach dem vorherigen Anspruch, wobei die erste Beschichtung und die zweite Beschichtung verschieden voneinander ausgebildet sind.

15. Licht emittierender Halbleiterchip nach dem vorherigen Anspruch, wobei eine Dicke der ersten Beschichtung im Bereich der ersten Seitenfläche zu einer Dicke der zweiten Beschichtung im Bereich der zweiten Seitenfläche ein Verhältnis zwischen einschließlich 1:1 und einschließlich 1:20 aufweist.

16. Licht emittierender Halbleiterchip nach einem der Ansprüche 12 bis 15, wobei in der Ausnehmung eine Füllung (15) vorhanden ist.

17. Licht emittierender Halbleiterchip nach einem der vorherigen Ansprüche, wobei jede der Emittereinheiten ein erstes Segment (25) und ein zweites Segment (26) aufweist, wobei das erste Segment von dem zweiten Segment durch die zumindest eine Ausnehmung (4) elektrisch und/oder optisch isoliert ist.

18. Licht emittierender Halbleiterchip nach dem vorherigen Anspruch, wobei für jede Emittereinheit das erste Segment einen Licht erzeugenden Teil aufweist und das zweite Segment ein Modulationselement ist, das dazu eingerichtet ist, eine Intensität der elektromagnetischen Strahlung des aktiven Bereichs zu modulieren.

19. Licht emittierender Halbleiterchip nach einem der vorherigen Ansprüche, wobei zumindest eine der Emittereinheiten ein Segment mit einem oder mehreren der folgenden Elemente aufweist: Fotodiode, passiver Wellenleiter, aktiver Wellenleiter, Strahlteiler, Strahlkombinierer, Linse wellenlängenselektives Element, Phasenschiebeelemente, Frequenzverdoppler, Taper, Verstärker, Konverter, Transistor.

20. Verfahren zur Herstellung eines Licht emittierenden Halbleiterchips (100) nach einem der vorherigen Ansprüche mit den Schritten:
- Herstellen eines Halbleiterkörpers (1) umfassend eine Mehrzahl von Emittereinheiten (101), wobei jede Emittereinheit einen aktiven Bereich (2) aufweist, der in einem Resonator mit einer Auskoppelseite (22) und einer Rückseite (20) angeordnet ist und der dazu vorgesehen und eingerichtet ist, im Betrieb Licht an der Auskoppelseite entlang einer Abstrahlrichtung (99) zu emittieren,
- Herstellen zumindest einer Ausnehmung (4) im Halbleiterkörper, durch die bei jeder Emittereinheit der aktive Bereich vollständig durchdrungen wird, wobei bei jeder Emittereinheit die zumindest eine Ausnehmung im Bereich des aktiven Bereichs eine Ausnehmungsbreite (A), die entlang der Abstrahlrichtung gemessen wird, aufweist, und die Ausnehmungsbreiten der Emittereinheiten unterschiedlich sind.

## Claims

1. A light-emitting semiconductor chip (100), comprising a semiconductor body (1) comprising a plurality of emitter units (101),
wherein
each emitter unit comprises an active region (2) which is arranged in a resonator having an outcoupling side (22) and a rear side (20) and which is intended and configured to emit light during operation at the outcoupling side along a radiation emission direction (99),
in each emitter unit the active region is completely penetrated by at least one recess (4) in the semiconductor body,
in each emitter unit, in the region of the active region the recess has a recess width (A) measured along the radiation emission direction,
**characterized in that**
the recess widths of the emitter units are at least partially different.

2. The light-emitting semiconductor chip of claim 1,
wherein the recess widths of the emitter units differ by an amount that is greater than or equal to 1 nm and less than or equal to 2 µm.

3. The light-emitting semiconductor chip according to any one of the preceding claims, wherein at least three emitter units are present and the recess widths of the emitter units differ equidistantly from each other.

4. The light-emitting semiconductor chip according to any one of the preceding claims, wherein each of the emitter units has at least one recess that is separate from the recesses of the other emitter units.

5. The light-emitting semiconductor chip according to any one of the preceding claims, wherein the at least one recess extends through the active regions of two or more emitter units.

6. The light-emitting semiconductor chip according to the preceding claim, wherein the recess width of the at least one recess increases continuously or stepwise from emitter unit to emitter unit.

7. The light-emitting semiconductor chip according to any one of the preceding claims, wherein the at least one recess has a rectangular base surface or an at least partially wedge-shaped and/or at least partially rounded base.

8. The light-emitting semiconductor chip according to any one of the preceding claims, wherein for each emitter unit the semiconductor body comprises a ridge waveguide structure (24) and the ridge waveguide structure comprises, in the region of the at least one recess, a thickening (24') along a main extension direction of the at least one recess.

9. The light-emitting semiconductor chip according to any one of the preceding claims, wherein, for each emitter unit, at least one recess is arranged in the region of the rear side.

10. The light-emitting semiconductor chip according to any one of the preceding claims, wherein, for each emitter unit, at least one recess is arranged in the region of the outcoupling side.

11. The light-emitting semiconductor chip according to any one of the preceding claims, wherein, for each emitter unit, the active region is completely penetrated by at least two recesses and wherein one of the recesses is arranged in the region of the rear side and the other of the recesses is arranged in the region of the outcoupling side.

12. The light-emitting semiconductor chip according to any one of the preceding claims, wherein, for each emitter unit, the at least one recess has at least one coating (10, 13, 15) that specifies a reflectivity of the recess for the light generated in the active region, the reflectivity being less than or equal to 99.9% and greater than or equal to 80%.

13. The light-emitting semiconductor chip according to any one of the preceding claims, wherein, for each emitter unit,
- the at least one recess has, in the radiation emission direction, a first side surface (6) and a second side surface (7) opposite the first side surface, and
- the first side surface has a first coating (10) which provides a reflectivity for the light generated in the active region and which is formed as a first layer sequence with a plurality of individual layers (12), and/or
- the second side surface has a second coating (13) which provides a reflectivity for the light generated in the active region and which is formed as a second layer sequence with a plurality of individual layers (12).

14. The light-emitting semiconductor chip according to the preceding claim, wherein the first coating and the second coating are embodied differently from each other.

15. The light-emitting semiconductor chip according to the preceding claim, wherein a thickness of the first coating in the region of the first side surface to a thickness of the second coating in the region of the second side surface has a ratio between 1:1 and 1:20, inclusive.

16. The light-emitting semiconductor chip according to any one of claims 12 to 15, wherein a filling (15) is provided in the recess.

17. The light-emitting semiconductor chip according to any one of the preceding claims, wherein each of said emitter units comprises a first segment (25) and a second segment (26), said first segment being electrically and/or optically isolated from said second segment by said at least one recess (4).

18. The light-emitting semiconductor chip according to the preceding claim, wherein, for each emitter unit, the first segment comprises a light generating part and the second segment is a modulating element adapted to modulate an intensity of the electromagnetic radiation of the active region.

19. The light-emitting semiconductor chip according to any one of the preceding claims, wherein at least one of the emitter units comprises a segment comprising one or more of the following: photodiode, passive waveguide, active waveguide, beam splitter, beam combiner, lens, wavelength selective element, phase shift elements, frequency doubler, taper, amplifier, converter, transistor.

20. A method for manufacturing a light-emitting semiconductor chip (100) according to any one of the preceding claims, comprising the steps of:
- producing a semiconductor body (1) comprising a plurality of emitter units (101), each emitter unit having an active region (2) which is arranged in a resonator having an outcoupling side (22) and a rear side (20) and which is intended and configured to emit light during operation at the outcoupling side along a radiation emission direction (99),
- producing at least one recess (4) in the semiconductor body, by means of which, for each emitter unit, the active region is completely penetrated, the at least one recess in the region of the active region having a recess width (A), which is measured along the radiation emission direction, for each emitter unit, and the recess widths of the emitter units being different.

## Revendications

1. Puce semi-conductrice électroluminescente (100) comportant un corps semi-conducteur (1) comprenant une pluralité d'unités émettrices (101),
chaque unité émettrice comportant une région active (2) qui est agencée dans un résonateur avec un côté de couplage (22) et un côté arrière (20) qui est conçu et configuré pour émettre de la lumière du côté de découplage le long d'une direction d'émission (99) pendant le fonctionnement,
pour chaque unité émettrice, la zone active est complètement traversée par au moins un évidement (4) dans le corps semi-conducteur,
pour chaque unité émettrice, l'évidement dans la zone de zone active présente une largeur d'évidement (A) qui est mesurée le long de la direction de rayonnement,
**caractérisée en ce que**
les largeurs d'évidement des unités émettrices sont au moins partiellement différentes.

2. Puce semi-conductrice électroluminescente selon la revendication 1, dans laquelle les largeurs d'évidement des unités émettrices diffèrent d'une quantité supérieure ou égale à 1 nm et inférieure ou égale à 2 µm.

3. Puce semi-conductrice électroluminescente selon l'une des revendications précédentes, dans laquelle au moins trois unités émettrices sont présentes et les largeurs d'évidement des unités émettrices diffèrent de manière équidistante les unes des autres.

4. Puce semi-conductrice électroluminescente selon l'une des revendications précédentes, dans laquelle chacune des unités émettrices comporte au moins un évidement séparé des évidements des autres unités émettrices.

5. Puce semi-conductrice électroluminescente selon l'une des revendications précédentes, dans laquelle au moins un évidement s'étend à travers les zones actives de deux ou plusieurs unités émettrices.

6. Puce semi-conductrice électroluminescente selon la revendication précédente, dans laquelle la largeur d'évidement du au moins un évidement augmente de manière continue ou par étapes d'une unité émettrice à l'autre.

7. Puce semi-conductrice électroluminescente selon l'une des revendications précédentes, dans laquelle le au moins un évidement présente une zone de base rectangulaire ou une zone de base au moins partiellement en forme de coin et/ou au moins partiellement arrondie.

8. Puce semi-conductrice électroluminescente selon l'une des revendications précédentes, dans laquelle le corps semi-conducteur présente pour chaque unité émettrice une structure de guide d'ondes en crête (24) et la structure de guide d'ondes en crête dans la zone d'au moins un évidement présente un épaississement (24 ') dans une direction d'extension principale du au moins un évidement.

9. Puce semi-conductrice électroluminescente selon l'une des revendications précédentes, dans laquelle au moins un évidement est disposé dans la zone située à l'arrière de chaque unité émettrice.

10. Puce semi-conductrice électroluminescente selon l'une des revendications précédentes, dans laquelle au moins un évidement est prévu pour chaque unité émettrice dans la zone du côté de découplage.

11. Puce semi-conductrice électroluminescente selon l'une des revendications précédentes, dans laquelle dans chaque unité émettrice la zone active est entièrement traversée par au moins deux évidements et l'un des évidements est disposé dans la zone du dos et l'autre des évidements est disposé dans la zone du côté de couplage.

12. Puce semi-conductrice électroluminescente selon l'une des revendications précédentes, dans laquelle dans chaque unité émettrice, au moins un évidement présente au moins un revêtement (10, 13, 15) qui détermine une réflectivité de l'évidement pour la lumière générée dans la zone active, la réflectivité étant inférieure ou égale à 99,9% et supérieure ou égale à 80%.

13. Puce semi-conductrice électroluminescente selon l'une des revendications précédentes, dans laquelle pour chaque unité émettrice
- le au moins un évidement dans la direction d'émission présente une première surface latérale (6) et une deuxième surface latérale (7) opposée à la première surface latérale, et
- la première surface latérale présente un premier revêtement (10) qui définit une réflectivité pour la lumière générée dans la zone active et qui est conçu comme une première séquence de couches avec une pluralité de couches individuelles (12), et/ou
- la deuxième surface latérale présente un deuxième revêtement (13) qui définit une réflectivité pour la lumière générée dans la zone active et qui est conçu comme une deuxième séquence de couches avec une pluralité de couches individuelles (12).

14. Puce semi-conductrice électroluminescente selon la revendication précédente, dans laquelle le premier revêtement et le deuxième revêtement sont conçus différemment l'un de l'autre.

15. Puce semi-conductrice électroluminescente selon la revendication précédente, dans laquelle une épaisseur du premier revêtement dans la région de la première surface latérale par rapport à une épaisseur du deuxième revêtement dans la région de la deuxième surface latérale a un rapport entre 1:1 et 1:20 inclus.

16. Puce semi-conductrice électroluminescente selon l'une des revendications 12 à 15, dans laquelle un remplissage (15) est présent dans l'évidement.

17. Puce semi-conductrice électroluminescente selon l'une des revendications précédentes, dans laquelle chacune des unités émettrices présente un premier segment (25) et un deuxième segment (26), le premier segment étant isolé électriquement et/ou optiquement du deuxième segment par le au moins un évidement (4).

18. Puce semi-conductrice électroluminescente selon la revendication précédente, dans laquelle pour chaque unité émettrice, le premier segment présente une partie génératrice de lumière et le deuxième segment est un élément de modulation qui est conçu pour produire une intensité de la pour moduler le rayonnement électromagnétique de la zone active.

19. Puce semi-conductrice électroluminescente selon l'une des revendications précédentes, dans laquelle au moins une des unités émettrices présente un segment avec un ou plusieurs des éléments suivants : photodiode, guide d'onde passif, guide d'onde actif, séparateur de faisceau, combineur de faisceau, lentille, longueur d'onde-élément sélectif, éléments déphaseurs, doubleur de fréquence, cône, amplificateur, convertisseur, transistor.

20. Procédé de fabrication d'une puce semi-conductrice électroluminescente (100) selon l'une des revendications précédentes avec les étapes:
- produire un corps semi-conducteur (1) comprenant une pluralité d'unités émettrices (101), chaque unité émettrice ayant une région active (2) qui se trouve dans un résonateur est disposé avec un côté de découplage (22) et un côté arrière (20) et qui est prévu et configuré pour émettre de la lumière du côté de découplage le long d'une direction d'émission (99) pendant le fonctionnement,
- produisant au moins un évidement (4) dans le corps semi-conducteur, à travers lequel la région active est entièrement pénétrée dans chaque unité émettrice, dans lequel au moins un évidement dans la région de la région active présente dans chaque unité émettrice une largeur d'évidement (A) qui est mesurée dans la direction du rayonnement et les largeurs d'évidement des unités émettrices sont différentes.
